(19) Europäisches Patentamt
European Patent Office
Office européen des brevets

(11) **EP 1 497 943 B1**

(12) **EUROPÄISCHE PATENTSCHRIFT**

(45) Veröffentlichungstag und Bekanntmachung des Hinweises auf die Patenterteilung:
**04.06.2014 Patentblatt 2014/23**

(21) Anmeldenummer: **03745745.4**

(22) Anmeldetag: **01.04.2003**

(51) Int Cl.:
**H04L 1/00** *(2006.01)*

(86) Internationale Anmeldenummer:
**PCT/DE2003/001061**

(87) Internationale Veröffentlichungsnummer:
**WO 2003/085873 (16.10.2003 Gazette 2003/42)**

(54) **VERFAHREN UND KOMMUNIKATIONSVORRICHTUNG ZUR ANPASSUNG DER DATENRATE IN EINER KOMMUNIKATIONSVORRICHTUNG**

METHOD AND COMMUNICATIONS DEVICE FOR ADAPTING THE DATA TRANSFER RATE IN A COMMUNICATIONS DEVICE

PROCEDE ET DISPOSITIF DE COMMUNICATION POUR ADAPTER LE DEBIT DE DONNEES DANS UN DISPOSITIF DE COMMUNICATION

(84) Benannte Vertragsstaaten:
**DE FR GB IT**

(30) Priorität: **08.04.2002 DE 10215380**
**29.04.2002 DE 10219151**

(43) Veröffentlichungstag der Anmeldung:
**19.01.2005 Patentblatt 2005/03**

(73) Patentinhaber: **Siemens Aktiengesellschaft**
**80333 München (DE)**

(72) Erfinder:
• **DÖTTLING, Martin**
**85579 Neubiberg (DE)**
• **RAAF, Bernhard**
**82061 Neuried (DE)**

(56) Entgegenhaltungen:
**WO-A-00/21234   WO-A-01/39420**
**WO-A-02/09294**

**Beschreibung**

Die vorliegende Erfindung betrifft ein Verfahren nach dem Oberbegriff des Anspruches 1 bzw. 2 zur Anpassung der Datenrate in einer Kommunikationsvorrichtung sowie eine entsprechende Kommunikationsvorrichtung nach dem Oberbegriff des Anspruches 4 bzw. 5.

Verschiedene Applikationen in Kommunikationssystemen arbeiten zumeist mit unterschiedlichen Datenraten. Die zugrunde liegenden Übertragungskanäle bieten aber meist z.B. wegen der Einbettung in gewisse Sendeformate, nur eine feste Datenübertragungsrate oder Roh-Datenübertragungsrate an, oder nur einen diskreten Satz solcher Datenraten. Es wird daher im allgemeinen notwendig sein, an der entsprechenden Schnittstelle die Datenraten aneinander anzupassen. Dies wird im folgenden an einem Beispiel aus der UMTS-Standardisierung beschrieben:

Augenblicklich wird an der Standardisierung des sogenannten UMTS-Mobilfunkstandards ('Universal Mobile Telecommunication System') für Mobilfunkgeräte der dritten Mobilfunkgeneration gearbeitet. Gemäß dem derzeitigen Stand der UMTS-Standardisierung ist vorgesehen, die über einen Hochfrequenzkanal zu übertragenden Daten einer Kanalcodierung zu unterziehen, wobei hierzu insbesondere Faltungscodes ('Convolutional Codes') verwendet werden. Durch die Kanalcodierung werden die zu übertragenden Daten redundant codiert, wodurch auf der Empfängerseite eine zuverlässigere Wiedergewinnung der gesendeten Daten möglich ist. Der bei der Kanalcodierung jeweils verwendete Code wird durch seine Coderate $r = k/n$ charakterisiert, wobei k die Anzahl der zu übertragenden Daten- oder Nachrichtenbits und n die Anzahl der nach der Codierung vorliegenden Bits bezeichnet. Je kleiner die Coderate ist, desto leistungsfähiger ist in der Bits wird als 'Punktieren' und das Verdoppeln als 'Repetie-ren' bezeichnet.

In der Offenlegungsschrift WO 01/39420 wird ein Verfahren offenbart, gemäß dem eine Punktierung bzw. Repetierung derart erfolgt, dass in jedem Frame eine gleich Anzahl von Bits entfernt wird. Dazu wird der Abstand der entfernten Bits zueinander für nachfolgende Frames beibehalten.

Gemäß dem derzeitigen Stand der UMTS-Standardisierung wird vorgeschlagen, zur Ratenanpassung einen Algorithmus zu verwenden, der eine Punktierung mit einem annähernd regelmäßigen Punktierungsmuster durchführt, d.h. die zu punktierenden Bits sind äquidistant über den jeweils zu punktierenden codierten Datenblock verteilt.

Darüber hinaus ist bekannt, dass beim Faltungscodieren die Bitfehlerrate (Bit Error Rate, BER) am Rand eines entsprechend codierten Datenblocks abnimmt. Ebenso ist bekannt, dass die Bitfehlerrate innerhalb eines Datenblocks durch ungleichmäßig verteiltes Punktieren lokal verändert werden kann. Diese Erkenntnisse wurden dazu genützt, heuristisch ein Punktierungsmuster zu finden, nach dessen Anwendung alle Bits des punktierten Datenblocks eine ihrer jeweiligen Wichtigkeit entsprechende Bitfehlerrate besitzen.

Der vorliegenden Erfindung liegt daher die Aufgabe zugrunde, ein Verfahren zur Anpassung der Datenrate eines Datenstroms in einer Kommunikationsvorrichtung und sowie eine entsprechende Kommunikationsvorrichtung bereitzustellen, welche zu einer zufriedenstellenden Bitfehlerrate führt und insbesondere in Mobilfunksystemen mit Faltungscodierung einsetzbar ist.

Diese Aufgabe wird erfindungsgemäß durch Verfahren mit den Merkmalen der unabhängigen Patentansprüche 1 und 2 bzw. durch Kommunikationsvorrichtungen mit den Merkmalen der Patentansprüche 4 und 5 gelöst. Abhängige Patentansprüche definieren bevorzugte und vorteilhafte Ausführungsformen der vorliegenden Erfindung.

Es ist weiterhin bekannt aus den Patentanmeldungen mit den Anmeldenummern 19948369.8 sowie 19956748.4 ( "Verfahren zur Anpassung der Datenrate in einer Kommunikationsvorrichtung und entsprechende Kommunikationsvorrichtungder gleichen Anzufriedenstellenden Bitfehlerrate gewährleisten und insbesondere in Mobilfunksystemen mit Faltungscodierung einsetzbar sind.

Diese Aufgabe wird erfindungsgemäß durch ein Verfahren mit den Merkmalen der Ansprüche 1 und 2 bzw. durch eine Kommunikationsvorrichtung mit den Merkmalen der Ansprüche 4 und 5 gelöst. Die Unteransprüche definieren bevorzugte und vorteilhafte Ausführungsformen der vorliegenden Erfindung.

Dabei wurde die Systematik des Faltungscodes dazu genützt, heuristisch Punktierungsmuster zu finden, nach deren Anwendung alle Bits des punktierten Datenblocks eine ihrer jeweiligen Wichtigkeit entsprechende Bitfehlerrate besitzen.

Vorzugsweise weist das Punktierungsmuster eine von dem mittleren Bereich zu beiden Enden des jeweiligen Datenblocks hin zunehmende Punktierungsrate auf. Auf diese Weise werden die Bits am Anfang und Ende des jeweils zu punktierenden Datenblocks stärker punktiert, wobei dies nicht mit einer gleichmäßigen Punktierungsrate, sondern mit einer im Wesentlichen zu den beiden Enden des jeweiligen Datenblocks hin ansteigenden Punktierungsrate erfolgt, d.h. der Abstand zwischen den punktierten Bits wird zu den beiden Enden des Datenblocks hin im Durchschnitt immer kürzer. Wie im weiteren ausgeführt werden wird, muss die Punktierungsrate aber überraschender Weise nicht unbedingt streng monoton zu den Enden hin ansteigen, oder anders ausgedrückt der Punktierungsabstand streng monoton abnehmen. Vielmehr kann es, bedingt durch die spezifischen Eigenschaften der verwendeten Faltungscodes und insbesondere der verwendeten Generatorpolynome auch vorteilhaft sein, etwas unregelmäßigere Muster zu verwenden.

Diese Punktierung führt zu einer über den punktierten Datenblock gleichmäßiger verteilten Fehlerrate der einzelnen Bits und hat zudem eine-verminderte Gesamtfehlerwahrscheinlichkeit zur Folge.

Die vorliegende Erfindung eignet sich insbesondere zur Anpassung der Datenrate eines faltungscodierten Datenstroms und kann somit bevorzugt in UMTS-Mobilfunksystemen eingesetzt werden, wobei dies sowohl den Bereich des Mobilfunksenders als auch den des Mobilfunkempfängers betrifft. Die Erfindung ist jedoch nicht auf diesen Anwendungsbereich beschränkt, sondern kann allgemein überall dort Anwendung finden, wo die Datenrate eines Datenstroms anzupassen ist.

Die vorliegende Erfindung wird nachfolgend unter Bezugnahme auf die beigefügte Zeichnung anhand bevorzugter Ausführungsbeispiele näher beschrieben. Es zeigen

Fig. 1: ein vereinfachtes Blockschaltbild eines erfindungsgemäßen Mobilfunksenders,

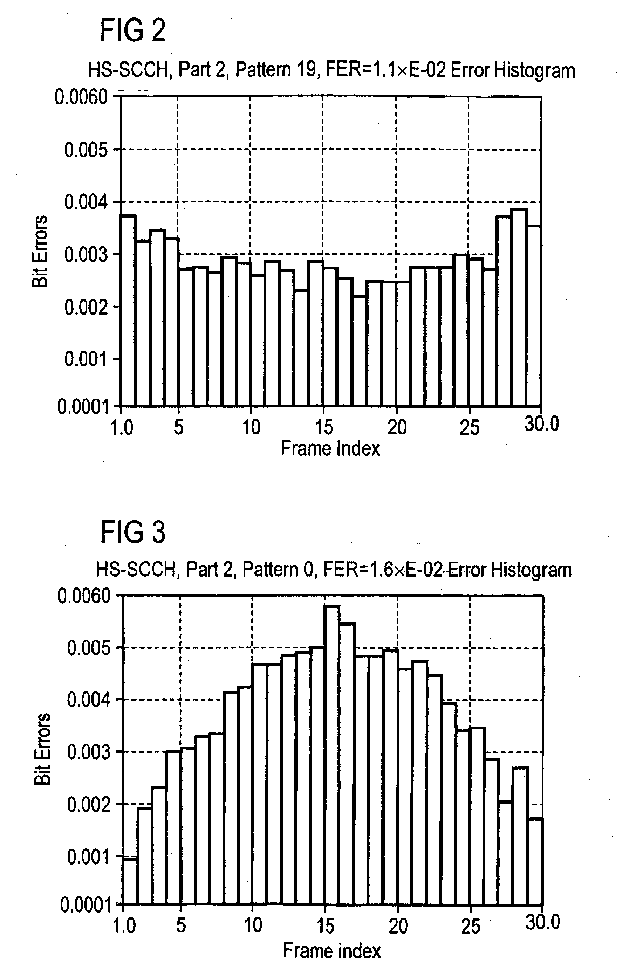

Fig. 2: die Bitfehlerrate BER pro Bit für die Punktierung gemäß einem Ausführungsbeispiel beim HS-SCCH, Part 2, Kodierung mir R=1/3 mit einem Verhältnis der Energie der übertragenen Bits zur Rauschleistungsdichte $E_s/N_0$ = -2 dB. Beim HS SCCH Kanal handelt es sich um den sogenannten High Speed Shared Controll Channel, über welchen gewisse Konfigurationsinformationen übertragen werden und der in zwei Teilbereiche, den sogenannten Part 1 und Part 2 aufteilbar ist. Part 1 wird hierbei zuerst übertragen und enthält die Informationen, die die Mobilstation zuerst braucht, um den folgenden Datenkanal zu verarbeiten, Part 2 enthält solche Informationen, die die Mobilstation erst etwas später benötigt. Durch diese Zweiteilung erreicht man, dass die Verzögerung durch den HS-SCCH so klein wie möglich ist, da nur der erste Teil dekodiert werden muss, bevor mit dem Empfang der Daten begonnen werden kann.

Fig. 3 : die Bitfehlerrate BER pro Bit für die -in UMTS (Spezifikation 25.212 v5.0.0, Kap. 4.2.7 "Rate matching") vorgeschlagene Ratenanpassung beim HS-SCCH, Part 2, bei einem Verhältnis der Energie der übertragenen Bits zur Rauschleistungsdichte von $E_s/N_0$ = -2· dB.

Fig. 4: einen Vergleich der mit einer erfindungsgemäßen Punktierung (obere Kurve, Kreuze) bzw. einer herkömmlichen Punktierung (untere Kurve, Kreise) hinsichtlich der daraus resultierenden Gesamtfehlerwahrscheinlichkeit erzielbaren Ergebnisse, wobei hier die Wahrscheinlichkeit, dass mindestens ein Bit eines Blocks fehlerhaft übertragen wurde (sog. Rahmenfehlerrate) aufgetragen ist.

Fig. 5:zugrundeliegende Schemen für Faltungscodes in UMTS.

Fig. 6 :die Bitfehlerrate BER pro Bit für die in UMTS (Spezifikation 25.212.v5.0.0, Kap. 4.2.7 "Rate matching") vorgeschlagene Ratenanpassung beim HS-SCCH, Part 1, bei einem Verhältnis der Energie der übertragenen Bits zur Rauschleistungsdichte von $E_s/N_0$ = -3 dB

Fig. 7: wie viele Eingangsbits (Input Bit) betroffen werden bei einer Punktierung eines Ausgangs-Bits in den verschiedenen Ausgangsstufen Output 1, Output 2 und Output 3.

Fig. 8: welche Eingangsbits (Bitnummern) durch die Punktierung betroffen sind.

Fig.9. : eine Tabelle mit den Ergebnissen der Punktierung in Abhängigkeit von der Anzahl der punktierten Bits.

Fig. 10 : die Bitfehlerrate BER pro Bit für eine Punktierung gemäß einem Ausführungsbeispiel beim HS-SCCH, Part 1, bei einem Signal-Rausch Verhältnis der Energie der übertragenen Bits zur Rauschleistungsdichte von $E_s/N_0$ = -3 dB

Fig. 11 : verschiedene Ausführungsbeispiele für eine Punktierung von 8 Bits (48 auf 40 Bit) für eine Kodierung mit Rate 1/3

Fig. 2: verschiedene Ausführungsbeispiele für eine Punktierung von 31 Bits (Punktierung von 111 auf 80 Bit), R = 1/3

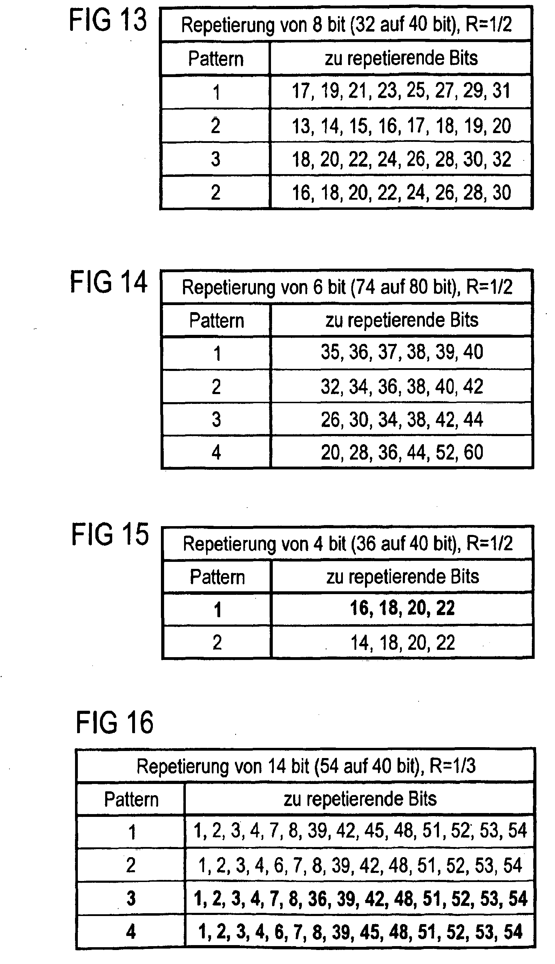

Fig. 13 : verschiedene Ausführungsbeispiele für eine Repetierung von 31 Bits (Repetierung von 32 auf 40 Bit), R = ½

Fig. 14 : verschiedene Ausführungsbeispiele für eine Repetierung von 6 Bits (74 auf 80 Bit), R = 1/3

Fig. 15 : verschiedene Ausführungsbeispiele für eine Repetierung von 4 Bit (36 auf 40 Bit), R = ½

Fig. 16 : verschiedene Ausführungsbeispiele für eine Punktierung von 14 Bit (54 auf 40 Bit), R = 1/3

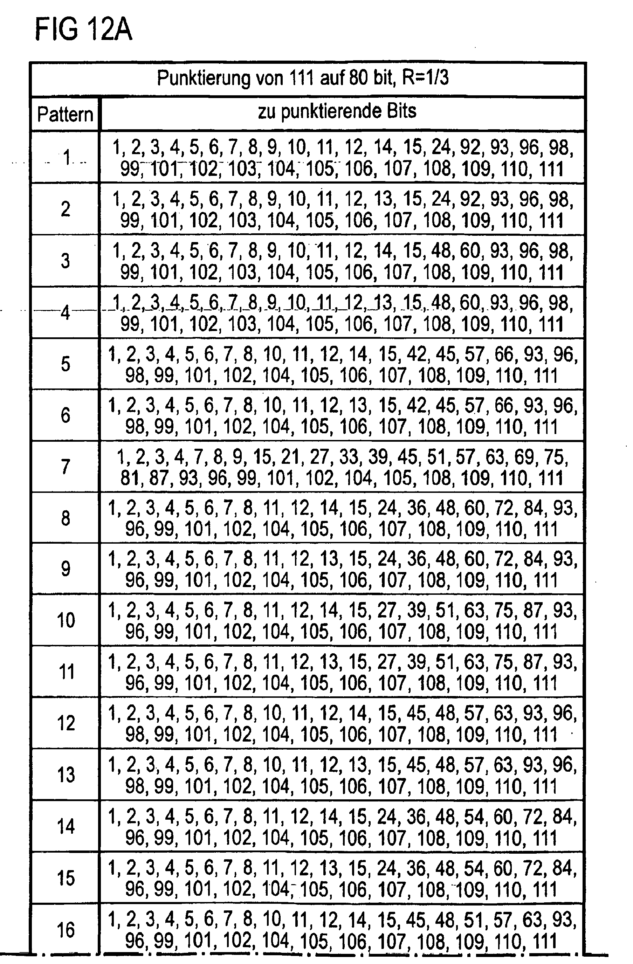

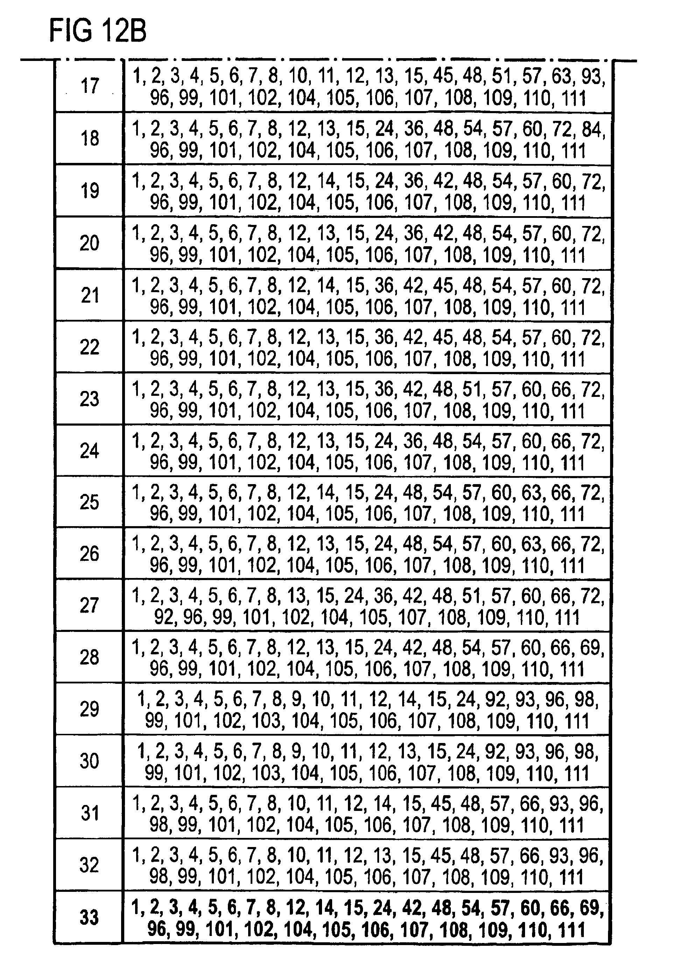

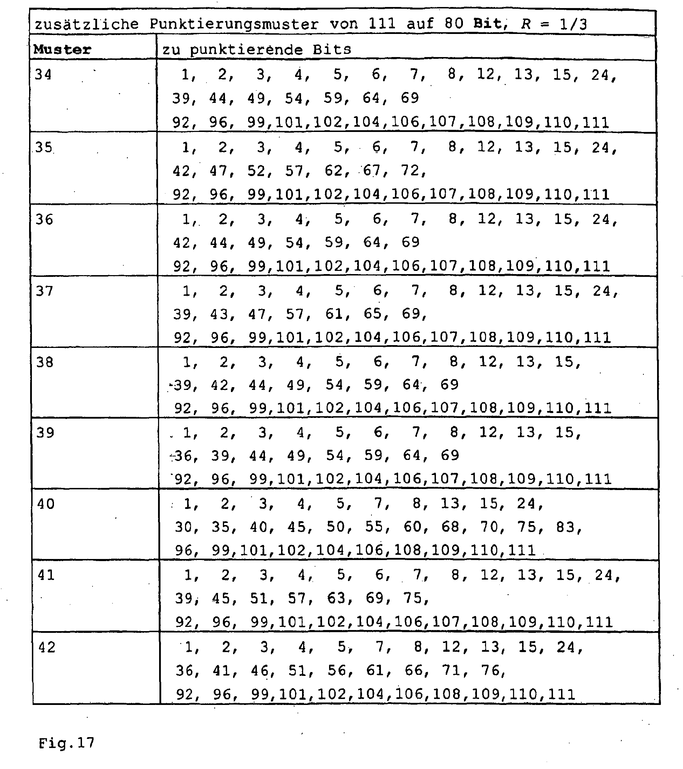

Fig. 17 : weitere Ausführungsbeispiele für eine Punktierung von 31 Bits (Punktierung von 111 auf 80 Bit), R = 1/3, Diese Figur kann also auch als eine Fortsetzung von Fig. 12 angesehen werden.

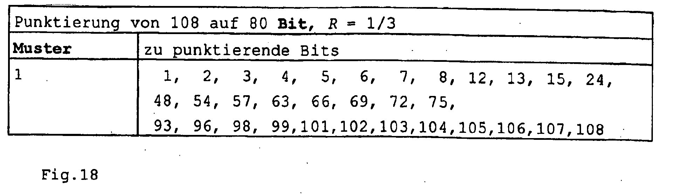

Fig.18 : ein Ausführungsbeispiel für eine Punktierung von 108 auf 80 Bits, R = 1/3

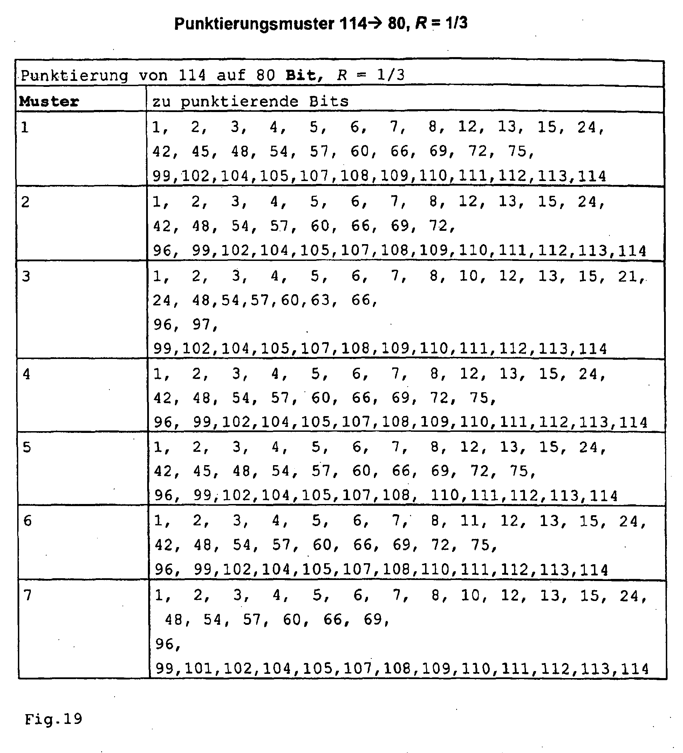

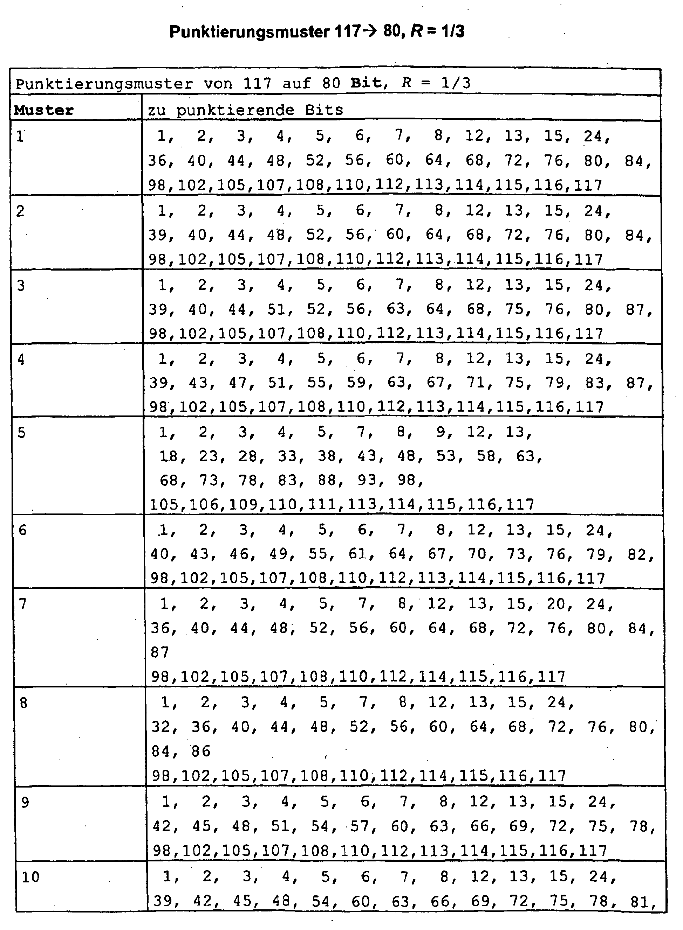

Fig. 19 : Ausführungsbeispiele für eine Punktierung von 114 auf 80 Bits, R = 1/3

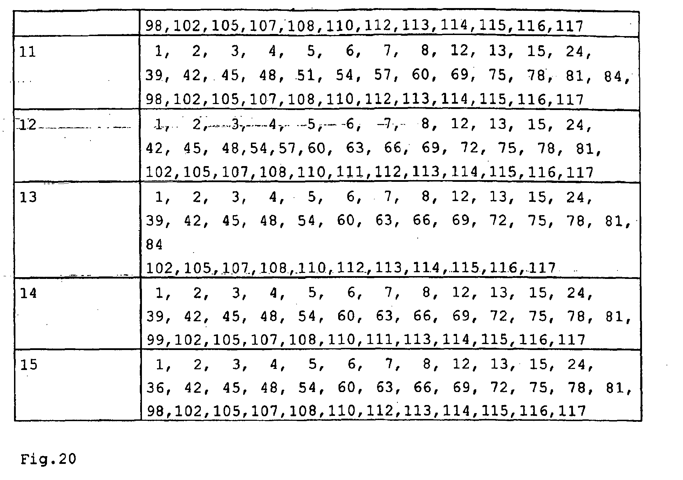

Fig. 20 : Ausführungsbeispiele für eine Punktierung von 117 auf 80 Bits, R = 1/3

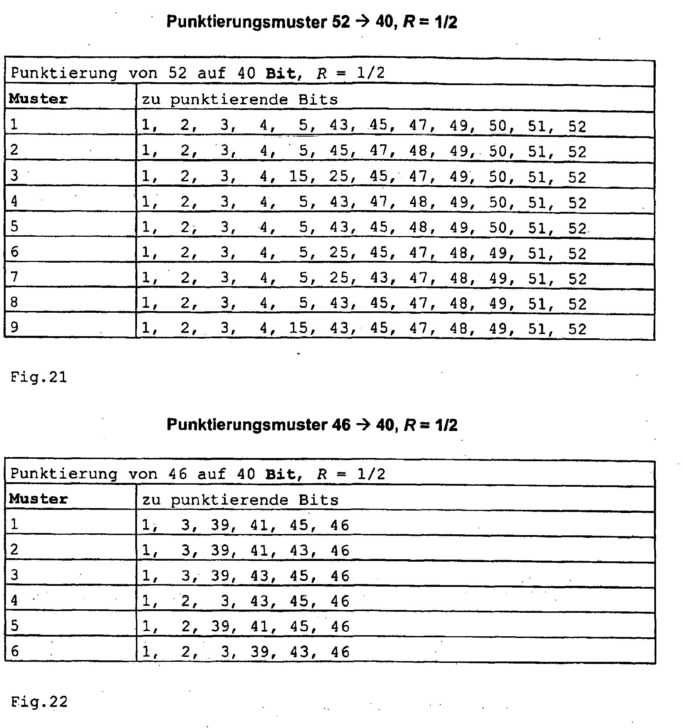

Fig. 21 : Ausführungsbeispiele für eine Punktierung von 52 auf 40 Bit, R = 1/2

Fig. 2.2 : Ausführungsbeispiele für eine Punktierung von 46 auf 40 Bit, R = 1/2

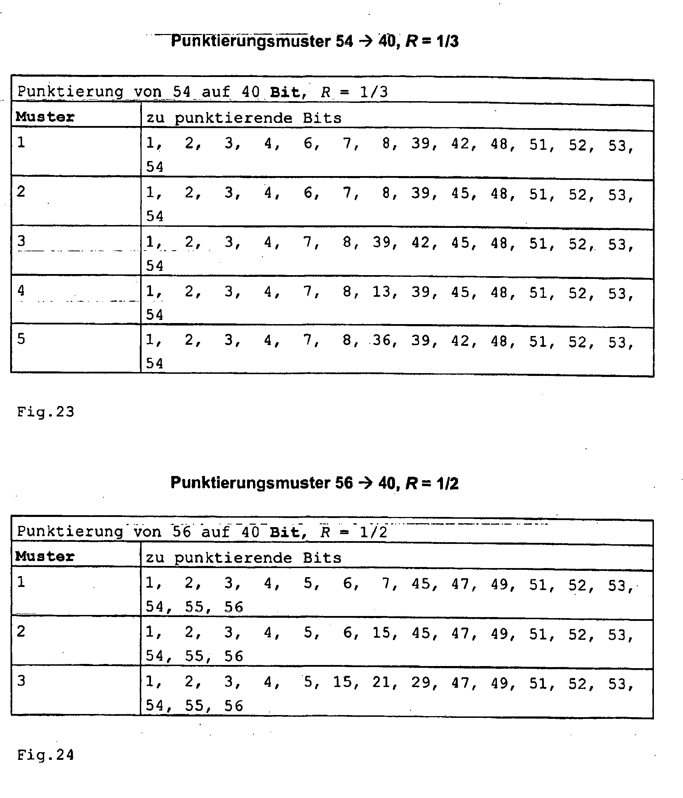

Fig. 23 : Ausführungsbeispiele für eine Punktierung von 54 auf 40 Bit, R = 1/3

Fig. 24 : Ausführungsbeispiele für eine Punktierung von 56 auf 40 Bit, R = 1/2

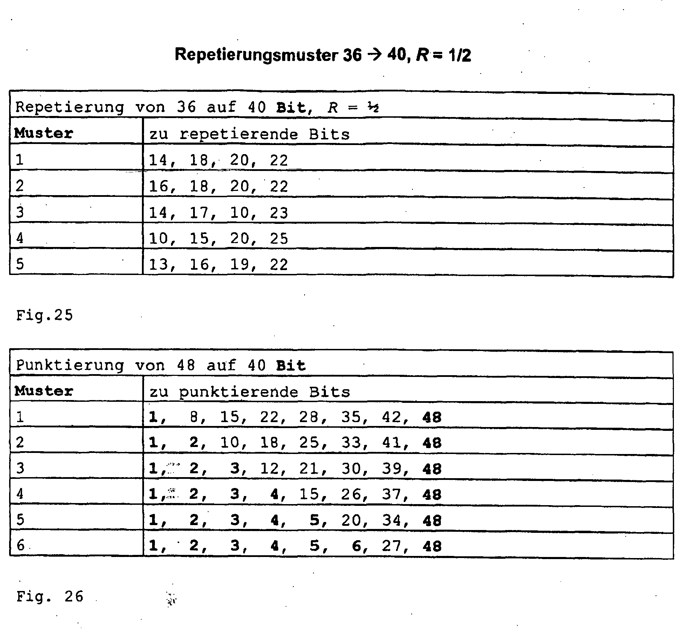

Fig. 25 : Ausführungsbeispiele für eine Repetierung von 36 auf 40 Bit, R = 1/2

Fig. 26 : Ausführungsbeispiele für eine Punktierung von 48 auf 40 Bits

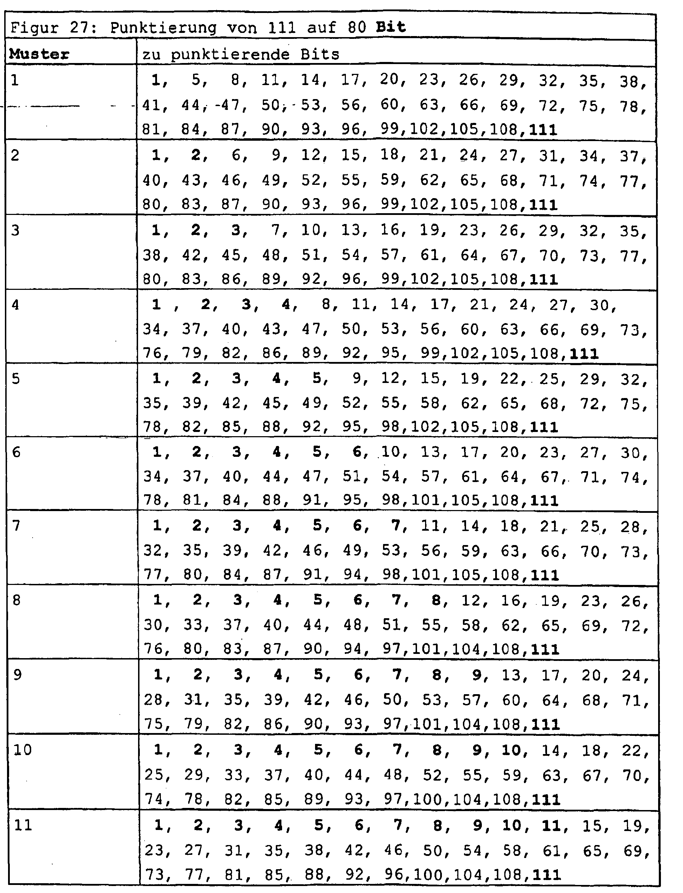

Fig. 27 : Ausführungsbeispiele für eine Punktierung von 11 auf 80 Bit.

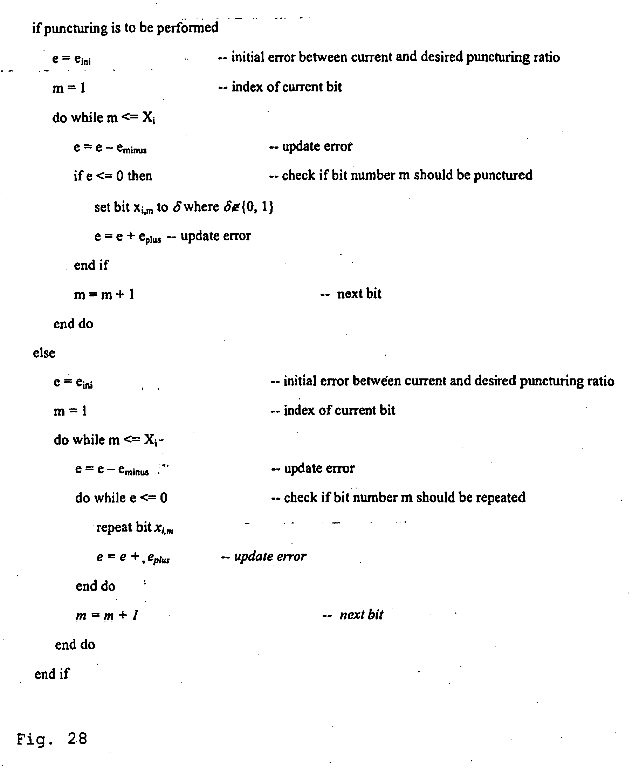

Fig. 28: Ratenanpassungsvorschrift aus der 3 GPP Spezifikation 25.212 v5.0.0, Kap. 4.2.7 "Rate matching" (Raterianpassung)

Allgemein bedeuten in den Tabellen die Zeilen mit zur Gänze fett gedruckten Zahlen das jeweils besonders bevorzugte Ausführungsbeispiel, wobei aber die Qualität der anderen Ausführungsbeispiel nicht notwendigerweise gravierend von diesem hervorgehobenen Ausführungsbeispiel abweicht. In den Figuren 26 und 27 jedoch bezeichnen fett eingetragenen Zahlen die durch das beschriebenen, erfindungsgemäße Konstruktionsprinzip der Ratenanpassungsformel punktierten bzw. repetierten Bits am Anfang bzw. Ende des Repetierungsmusters. Diese sind somit festgelegt, wohingegen sich die Position der nicht fett gezeichneten Bits durch Variation der Parameter im Rahmen dieser Erfindung auch leicht (typischerweise um eine Position) verschieben können.

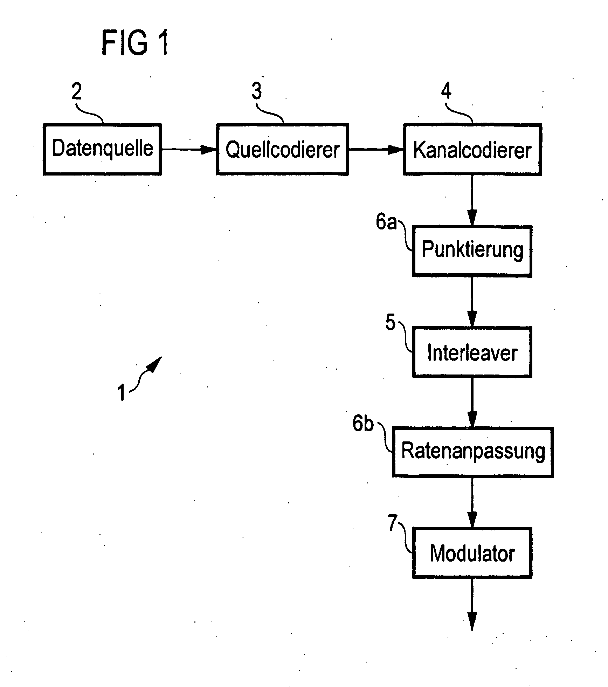

In Fig. 1 ist schematisch der Aufbau eines erfindungsgemäßen Mobilfunksenders 1 dargestellt, von dem Daten oder Kommunikationsinformationen, insbesondere Sprachinformationen, über einen Hochfrequenz-Übertragungskanal an einen Empfänger übertragen werden. In Fig. 1 sind insbesondere die an der Codierung dieser Informationen oder Daten beteiligten Komponenten dargestellt. Die von einer Datenquelle 2, beispielsweise einem Mikrofon, gelieferten Informationen werden zunächst mit einem digitalen Quellcodierer 3 in eine Bitfolge umgesetzt. Die sprachcodierten Daten werden anschließend mit Hilfe eines Kanalcodierers 4 codiert, wobei die eigentlichen Nutz- oder Nachrichtenbits redundant codiert werden, wodurch Übertragungsfehler erkannt und anschließend korrigiert werden können. Bei dem Kanalcodierer 4 kann es sich um einen Faltungskodierer handeln.Die sich bei der Kanalcodierung ergebende Coderate r ist eine wichtige Größe zur Beschreibung des jeweils bei der Kanalcodierung eingesetzten Codes und ist, wie bereits erwähnt worden ist, durch den Ausdruck r = k/n definiert. Dabei bezeichnet k die Anzahl der Datenbits und n die Anzahl der insgesamt codierten Bits, d.h. die Anzahl der hinzugefügten redundanten Bits entspricht dem Ausdruck n - k. Ein Code mit der oben definierten Coderate r wird auch als (n,k)-Code bezeichnet, wobei die Leistungsfähigkeit des Codes mit abnehmender Coderate r zunimmt. Zur Kanalcodierung werden üblicherweise sogenannte Blockcodes oder Faltungscodes verwendet.

Nachfolgend soll davon ausgegangen werden, dass - wie durch den derzeitigen Stand der UMTS-Standardisierung festgelegt ist - bei der Kanalcodierung Faltungscodes zur Anwendung kommen. Ein wesentlicher Unterschied zu Blockcodes besteht darin, dass bei Faltungscodes nicht einzelne Datenblöcke nacheinander codiert werden, sondern dass es sich um eine kontinuierliche Verarbeitung handelt, wobei jedes aktuelle Codewort einer zu codierenden Eingangssequenz auch von den vorhergehenden Eingangssequenzen abhängt. Unabhängig von der Coderate r = k/n werden Faltungscodes auch durch die sogenannte Einflußlänge oder 'Constraint Length' K charakterisiert. Die 'Constraint Length' gibt an, über wie viele Takte von k neuen Eingangsbits des Kanalcodierers 4 ein Bit das von dem Kanalcodierer

ausgegebene Codewort beeinflusst.

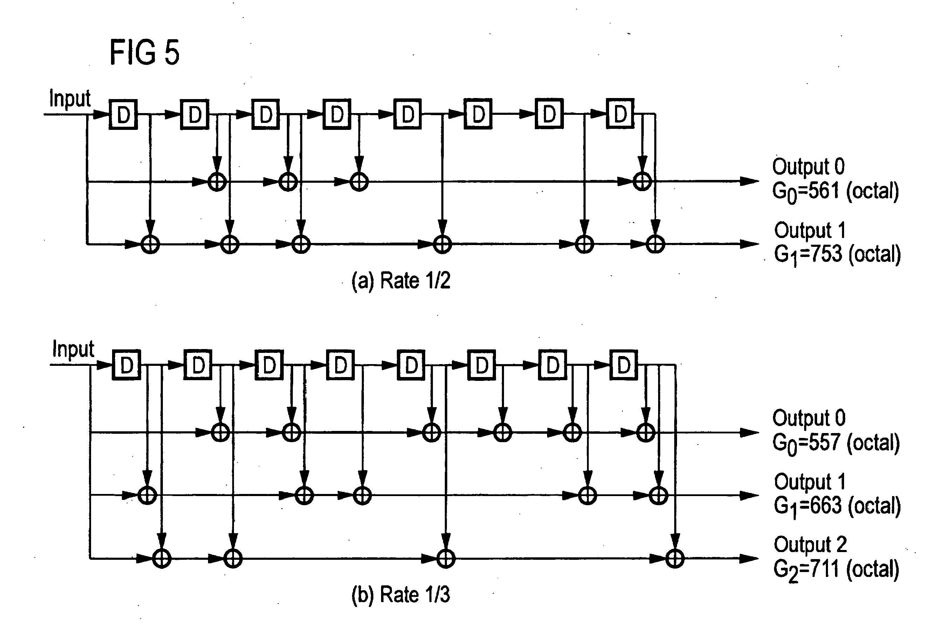

Für UMTS werden die folgenden Faltungscodes verwendet, wie in Figur 5 gezeigt. Die Abbildung ist aus der Spezifikation 25.212 Kap. 4.2.3.1 "Convolutional coding" (Faltungskodes)entnommen.

Vor der Übertragung der kanalcodierten Informationen zu dem Empfänger können diese einem Interleaver 5 zugeführt werden, der die zu übertragenden Bits gemäß einem bestimmten Schema zeitlich umordnet und dabei zeitlich spreizt, wodurch die in der Regel bündelweise auftretenden Fehler verteilt werden, um einen sogenannten gedächtnislosen (memoryless) Übertragungskanal mit einer quasizufälligen Fehlerverteilung zu erhalten. Die auf diese Weise codierten Informationen oder Daten werden einem Modulator 7 zugeführt, dessen Aufgabe es ist, die Daten auf ein Trägersignal aufzumodulieren und gemäß einem vorgegebenen Vielfachzugriffsverfahren über einen Hochfrequenz-Übertragungskanal 3 an einen Empfänger zu übertragen.

Zur Übertragung wird der codierte Datenstrom in Datenblöcke aufgeteilt, wobei der Kanalcodierer 4 zu Beginn eines Datenblocks in einen bekannten Zustand gesetzt wird. Am Ende wird jeder codierte Datenblock durch sogenannte 'Tailbits' abgeschlossen, so dass der Kanalcodierer 4 sich wieder in einem bekannten Zustand befindet. Durch diesen Aufbau des Faltungscodes sowie des Kanalcodierers 4 wird erreicht, dass die Bits am Anfang und Ende eines codierten Datenblocks besser als in der Blockmitte gegen Übertragungsfehler geschützt sind. Dabei ist es unerheblich ob diese Tailbits alle den bekannten Wert 0 haben, oder einen anderen Wert. Die Werte dieser Tailbits können auch beliebig gewählt werden, wobei sowohl Sender als auch Empfänger die zu verwendenden Werte kennen müssen.

Die Fehlerwahrscheinlichkeit eines Bits ist abhängig von seiner Lage innerhalb des jeweiligen Datenblocks unterschiedlich. Dieser Effekt wird beispielsweise bei der Sprachübertragung in GSM-Mobilfunksystemen ausgenützt, indem die wichtigsten Bits an den beiden Blockenden platziert werden, wo die Fehlerwahrscheinlichkeit am geringsten ist. Bei Datenübertragungen werden jedoch im allgemeinen Datenpakete bereits dann verworfen, wenn nur ein einziges übertragenes Bits fehlerhaft ist, was beispielsweise im Empfänger durch einen sogenannten 'Cyclic Redundancy Check' (CRC) festgestellt werden kann. Daher kann bei einer Datenübertragung nicht von wichtigen oder weniger wichtigen Bits gesprochen werden, sondern alle Bits sind als gleich wichtig anzusehen. Wenn Fehler in einem Kontrollblock auftreten, also einem Datenblock, der Kontroll-Information enthält, welche Informationen darüber enthält, wie nachfolgende Nutzdaten kodiert und übertragen werden, so ist im allgemeinen einen korrekte Detektion dieser Nutzdaten schon dann nicht mehr möglich, wenn nur ein einziges Bit falsch empfangen wird, da die Empfangsdaten dann falsch interpretiert werden.

Um die Datenrate des codierten Datenstroms an die jeweils mögliche Übertragungsrate anzupassen, wird vor dem Modulator 7 eine Ratenanpassung ('Rate Matching') durchgeführt. Bei dem in Fig. 1 gezeigten Ausführungsbeispiel findet die Ratenanpassung in der Ratenanpassungseinheit 6b statt, wobei die Punktierungseinheit 6a zunächst eine Punktierung gemäß einem bestimmten Punktierungsmuster durchführt, um eine gleichmäßigere Fehlerverteilung über einen Datenblock zu erzielen. Die in Fig. 1 gezeigte Reihenfolge der Punktierungseinheit 6a sowie des Interleavers 5 sind lediglich beispielhaft zu verstehen. Der Interleaver kann auch nach der Einheit 6b angeordnet sein. Ebenso kann der Interleaver 5 auch durch zwei Interleaver vor und nach der Ratenanpassungseinheit 6b ersetzt sein usw.

Es ist also auch eine Aufgabe dieser Erfindung, Punktierungsmuster weiter zu optimieren und insbesondere an die für den Kanalcodierer verwendeten Polynome anzupassen. Es stellt sich also die Aufgabe, abhängig vom verwendeten Faltungscode (einschließlich der verwendeten Polynome) und der Blocklänge die Menge der zu punktierenden bzw. repetierenden Bits so auszuwählen, dass die Dekodierung möglichst gut durchgeführt werden kann. In der Regel ergeben sich eine große Anzahl an Möglichkeiten, so dass es zumindest sehr zeit- und ressourcenaufwändig ist, ein sehr gutes Ratenanpassungsmuster rein durch Simulation zu entwickeln. Möchte man beispielsweise alle möglichen Punktierungsmuster zur Punktierung von 48 Bit auf 40 Bit untersuchen, so wären das 48!/(8!*.40!) = 377348994 verschiedene Möglichkeiten, die in vertretbarer Zeit nicht untersucht werden können.

Dieses Problem stellt sich insbesondere für kurze Blocklängen, wie z. B. für die Kontrollinformation der UMTS-Erweiterung HSDPA, und dort insbesondere den HS-SCCH Kanal (High Speed Shared Controll CHannel). Dieser Kanal überträgt Konfigurationsinformationen, welche angeben, wie die eigentlichen,über einen speziellen Datenkanal gesendete Nutzdaten , kodiert sind und weitere Details, z.B. die zur Übertragung verwendeten Spreizcodes. Im Gegensatz zum Datenkanal, über den sehr viele Daten übertragen werden können sind das vergleichsweise wenig Daten. In UMTS werden zur Kodierung Faltungscodes mit der Rate ½ oder 1/3 verwendet, die verwendeten Polynome sind in Fig. 5 gezeigt. Als Polynome bezeichnet man auch die genaue Gestaltung der "Abgreifpunkte", also welche Verzögerungsstufen für die einzelnen Ausgangsbitströme abgegriffen und durch eine Exclusiv-Oder Operation verknüpft werden.

Die Erfindung ist somit insbesondere anwendbar für den sogenannten HS-SCCH (High Speed Shared Controll CHannel).

Die Definition der Kodierung des HS-SCCH ist nach derzeitigem Stand der Technik in der Spezifikation 3GPP TS 25.212 V5.0.0 (2002-03), "Multiplexing and channel coding (FDD) (Release 5)" gegeben, insbesondere im Kapitel 4.6 "Coding for HS-SCCH". Diese Spezifikation wird ansonsten in dieser Anmeldung auch kurz als 25.212 bezeichnet. Im Unterkapitel 4.6.6 "Rate matching for HS-SCCH" wird festgelegt, dass die Ratenanpassung gemäß dem Standard-Ratenanpassungsalgorithmus in Kapitel 4.2.7 "Rate matching" durchgeführt werden muss, der im wesentlichen eine (möglichst) äquidistante Punktierung bzw. Repetierung bewirkt.

Die Blocklänge der beiden Teile des HS-SCCHs beträgt nach derzeitigem Stand 8 Bit für den ersten Teil, oder falls die Endbits (Tail Bits) miteingeschlossen werden 16 Bit, 29 Bit für den zweiten Teil, oder falls auch die Endbits (Tail Bits) miteingeschlossen werden 37 Bits. Da die Spezifikation noch im Fluss ist, können sich aber durch Veränderungen an verschiedenen Parametern auch andere Blocklängen ergeben. Des weiteren kommen auch noch die Faltungscodes mit der Rate ½ oder 1/3 in Frage. Insbesondere die folgenden Ratenanpassungen sind relevant:

a) 32 auf 40 (mit Code-Rate R = 1/2), oder
b) 48 auf 40 (mit Code-Rate R = 1/3), und
c) 74 auf 80 (mit Code-Rate R = 1/2), oder
d) 111 auf 80 (mit Code-Rate R = 1/3).

**Vorgehen zur Bestimmung von Punktierungs- und Repetierungsmustern**

Im Überblick lässt sich also feststellen, dass bei einer Ratenanpassung eine Punktierung und/ oder Repetierung oder auch eine Repetierung alleine so vorgenommen wird, dass die gesamte Bitfehlerrate (BER) minimal wird. Dazu sei zunächst die Situation in Fig.3 betrachtet: Hier ist die Bitfehlerrate für die einzelnen Bits in einem Rahmen (Frame) aufgetragen. Die Abszisse gibt den Index des jeweiligen Bits "(Frame Index)" wieder. Man sieht deutlich, dass die ersten und letzten Bits eine geringere Bitfehlerrate aufweisen. Dies lässt sich in Zusammenhang mit dem Schema für Faltungscodes aus Figur 5 verstehen: Für die Übertragung werden durch den Faltungscode jeweils Bits aus den verschiedenen Verzögerungsstufen D des Dekodierers miteinander verknüpft. Die ersten Bits werden z.B. auch mit den ihnen vorhergehenden Bits, also eigentlich nicht existierenden Bits verknüpft. Diese "nicht existierenden Bits" werden dann auf einen bekannten Wert, meist Null gesetzt. Dies ist dem Empfänger bekannt, der nun seinerseits mit diesen auf Null gesetzten Bits die ersten übertragenen Bits decodiert. Eine Decodierung ist hier sehr sicher, da ein Teil der Bits mit absoluter Sicherheit bekannt ist.

Dasselbe trifft zu für die letzten Bits: In Anschluss an sie werden wieder künstlich Bits, die sogenannten End- Bits oder "tail Bits", in die Verzögerungsgliedern D des Decodierers eingefügt werden; diese End-Bits werden wiederum auf einen bekannten Wert, meist Null gesetzt.

Im mittleren Bereich werden Bits miteinander verknüpft, deren Wert am Empfänger nicht mit Sicherheit bekannt ist. Somit ist bei der Decodierung die Wahrscheinlichkeit größer, das ein Fehler auftritt, was sich in einer höheren Bitfehlerrate äußert.

Die Hüllkurve der Bitfehlerrate gegenüber der Rahmennummer ist also hier bei gleichmäßiger Repetierung oder Punktierung zunächst einmal nach oben konvexartig ausgeformt.

Es gibt nun verschiedene Möglichkeiten, wie sich die Hüllkurve verändert, wenn die Punktierung (oder Repetierung)verändert wird:

a) die Hüllkurve stellt im Wesentlichen eine Horizontale dar (oder nähert sich ihr an):

Das bedeutet, dass die Bitfehlerrate für alle Bits innerhalb eines Rahmens im Wesentlichen gleich ist. Dies geschieht beispielsweise durch eine Punktierung am Rande oder eine Repetierung in der Mitte, oder beides, auch abhängig davon, auf welche Rate angepasst werden soll.

b)konkavartige Ausbildung der Hüllkurve
In diesem Falle wird beispielsweise am Rand so stark punktiert, dass die Bits im mittleren Bereich des Rahmens eine geringere Bitfehlerrate aufweisen. Dieser Sachverhalt ist in Figur 2 zu sehen.
c) die Bitfehlerrate ist unregelmäßig gegenüber der Rahmennummer verteilt. Dieser Fall wird aus weiter unten ausgeführten Gründen hier nicht näher betrachtet.

Die folgenden Ausführungen beziehen sich auf das Punktieren. Analoge Überlegungen können auch für das Repetieren angestellt werden oder auch für Kombinationen aus Repetieren und Punktieren:

Es gibt nun sehr viele Möglichkeiten, wie einzelne Bits punktiert werden können. Möchte man beispielsweise, wie bereits weiter oben ausgeführt, alle möglichen Punktierungsmuster zur Punktierung von 48 Bit auf 40 Bit untersuchen, so wären das 48!/(8!*40!) = 377348994 verschiedene Möglichkeiten, die in vertretbarer Zeit nicht alle untersucht werden können.

Ziel ist es daher, von vorneherein nicht sinnvolle Möglichkeiten zu eliminieren. Dies geschieht nicht über beliebiges Repetieren und/oder Punktieren, weshalb Alternative c) hier nicht weiter betrachtet wird.

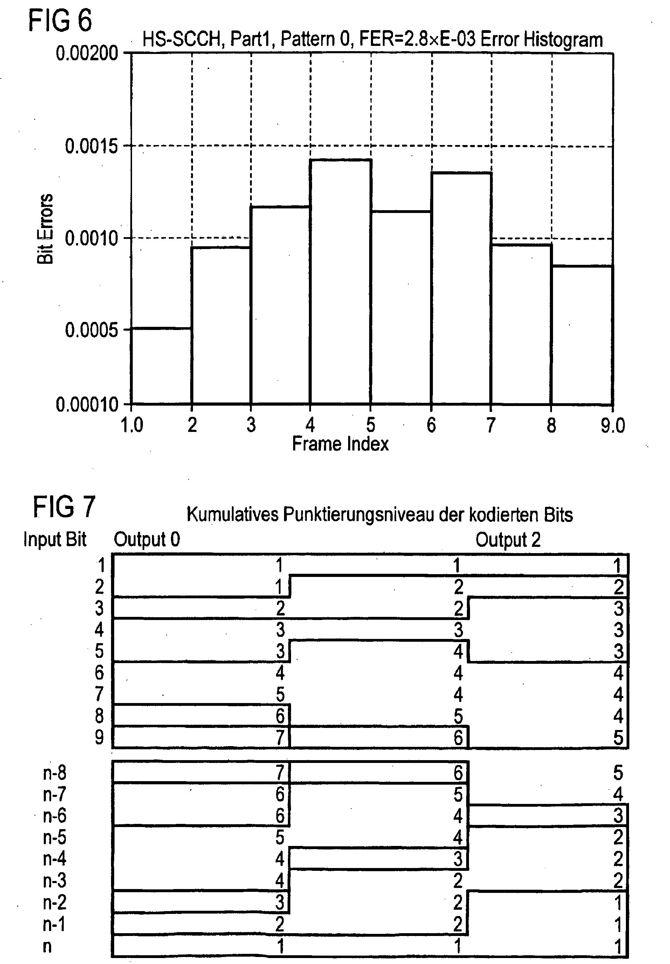

Ein Ordnungsprinzip ist in Figur 7 gezeigt. Für die ersten 9 Inputbits 1-9 sowie die letzten 9 Inputbits n-8 bis n wird das Punktierungsniveau für die jeweilige Ausgangsstufe Output 0, Output 1, Output 2 aufgezeigt. Die Ausgangsstufen selbst sind, wie in Fig. 5 zu sehen, die jeweilige Ausgangsfunktion, die aus allen, dem momentan betrachteten Inputbit zeitlich vorhergehenden Inputbits durch Verknüpfung gebildet wird. Hier werden die Ausgangsstufen von Fig. 5b) betrachtet, also den Rate 1/3 Faltungsencoder (convolutional encoder). Für ein Punktieren mit möglichst geringem Informationsverlust bietet es sich an, zunächst Bits wegzulassen (Punktieren), die wenig Einfluss auf andere Bits haben. Das Punktierungsniveau gibt also an, wie viele Bits durch eine Punktierung des betrachteten Bits beeinflusst werden.

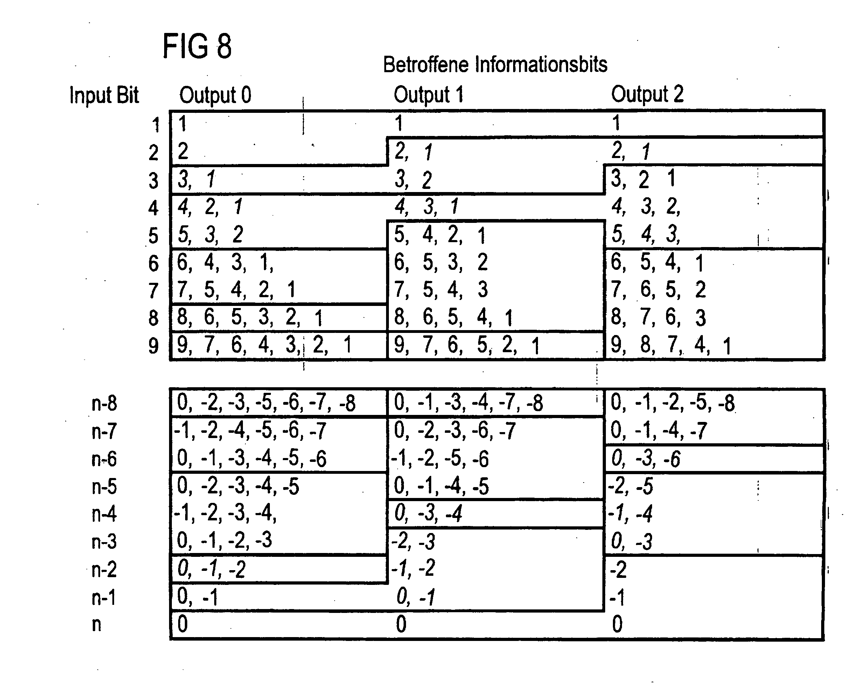

Eine beispielhafte Vorgehensweise für das Weglassen oder Punktieren von Bits ist in Figur 8 gezeigt. In der ersten Spalte sind wieder die ersten 9 Inputbits 1-9 angegeben, sowie die letzten 9 Inputbits n-8 bis n. In den folgenden Spalten sind die Bitnummern der von der Punktierung betroffenen Informationsbits, also Informationsbits oder Eingangsbits, für die jeweilige Ausgangsstufe Output 0, Output 1 und Output 2 gezeigt. Die Tabellenfelder sind - wie schon in Fig.7 - mit steigender Anzahl der beeinflussten Informationsbits zunehmend dunkler hinterlegt. Die zu den hellen Tabellenfeldern gehörenden Bits sind also Kandidaten für das Punktieren.

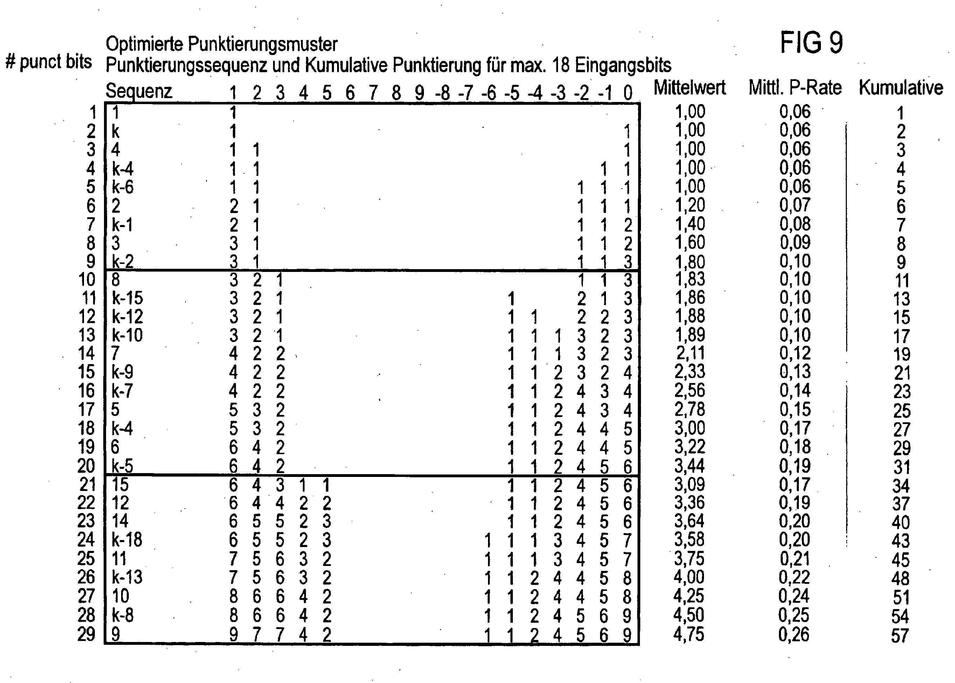

In Figur 9 ist eine Tabelle aufgeführt, in der die wichtigen Größen bei Punktierung in der Nähe der Enden, also Punktierung der ersten und letzten Bits, beleuchtet werden. Es werden n Eingangsbits (Informationsbits) und k kodierte Bits (Bits an der Ausgangsstufe, Ausgangsbits) betrachtet. In der ersten Spalte ist die Anzahl der punktierten Ausgangsbits (# punct bits) angegeben, in der letzten Spalte (Kumulative) die Anzahl der davon betroffenen Informationsbits am Eingang, wobei Eingangsbits, die mehrfach betroffen sind, also durch die Punktierung von mehreren Ausgangsbits, auch entsprechend mehrfach gezählt werden.

In der zweiten Spalte ist unter Sequenz angegeben, welches Ausgangsbit (Bitnummer) in diesem Schritt punktiert wurde. Die Punktierung erfolgt dabei, beginnend mit den am wenigsten wichtigen Bits in der ersten Zeile, hin zu den folgenden Bits in den folgenden Zeilen Das. Gesamt-Punktierungsmuster für z.B. 7 zu punktierende Bits ergibt sich somit aus den in Spalte 2 in den Zeile 1 bis 7 angegebenen Bits, also den Bits 1, k, 4, k-4, k-6, 2, k-1. Dieses Muster umfasst also die Bits 1, 2, 4, k-6, k-4, k-1, k. Oberhalb der ersten Zeile befindet sich die Indizierung für die ersten Informationsbits 1-9 sowie die letzten Informationsbits k-8 bis k. Aus Platzgründe wird statt k-8 nur -8 usw. geschrieben. Die Einträge in den Spalten unter der Indizierung der Informationsbits geben an, wie stark das betreffende Informationsbit durch die Punktierung der Ausgangsbits, die in der 2. Spalte bis zur jeweiligen Zeile angegeben sind und also punktiert werden, betroffen wird. Das heißt, wie viele der punktierten Ausgangsbits waren mit diesem Informationsbit verknüpft. Das ist ein Maß dafür, wie stark das betreffende Informationsbit durch die Punktierung geschwächt wurde.

In der letzten Spalte (Kumulative) ist schließlich die Summe dieser Beeinträchtigungen aufgeführt. Sie wird hier kumulativen Punktierungsstärke genannt.

Die Spalte Mittelwert gibt das Verhältnis V der Summe der letzten Spalte beteilt durch die Anzahl der betroffenen Informationsbits an. Beispielsweise ergibt sich für 6 punktierte Bits V=(2+1+1+1+1)/(1+1+1+1+1) =1,2 Die mittlere Punktierungsrate (Mittl. P-Rate) ist die Spalte "Mittelwert" geteilt durch 18, die Gesamtzahl der pro Informationsbit bei der Encodierung auftretenden "exclusiv oder"-Verknüpfungen.

Eine Vorgehensweise, um eine beliebige Anzahl von Bits zu punktieren, besteht-darin, Tabellen analog den oben genannten anzufertigen. Für Rate 1/3 und die betrachteten Polynome des Faltungskodierers können die gezeigten Tabellen verwendet werden. Bei anderen Kodierungsraten und/oder anderen Polynomen können die'Tabellen leicht analog bestimmt werden. Mit Hilfe dieser Tabellen legt man dann eine Punktierungsreihenfolge fest, wo zuerst solche Ausgangsbits punktiert werden, die nur einen geringen Einfluss auf die kumulativen Punktierungsstärke haben. Gibt es dabei mehrere Alternative, so werden bevorzugt solche Bits punktiert, welche das Maximum der Punktierungsstärke der einzelnen Bits minimieren.

Für höhere Anzahl zu punktierender Bits und/oder größeren Blocklängen muss i. d. R. die Information aus den Tabellen mit der Idee, möglichst gleichverteilt über den gesamten Block zu punktieren, kombiniert werden. Es bietet sich dann an, im mittleren Teil zusätzlich gezielt Bits zu punktieren, die vom Generatorpolynom mit den wenigsten Potenzen, d.h. mit den wenigsten Verknüpfungen generiert werden. Gleichzeitig ist jedoch darauf zu achten, dass die Gesamtverteilung der Punktierungsstärke im mittleren Bereich des Rahmens keine deutlichen Überhöhungen aufweist.

Für Repetierung gilt entsprechendes, jeweils mit umgekehrtem Vorzeichen. Das heißt, dass Bits die gemäß der Heuristik zuerst punktiert würden nun zuletzt repetiert werden und dass generell zuerst eine gleichmäßige Repetierung im Mittelteil durchgeführt wird, bevorzugt von den Polynomen mit den meisten Verknüpfungen. Danach werden am Rand solche Bits repetiert, die (bei Punktierung) einen möglichst großen Einfluss auf'die kumulativen Punktierungsstärke haben.

Im Unterschied zu Verfahren, bei denen die Punktierungsrate zu den Enden hin stetig zunimmt, führt dies zu einem an sich ein unerwarteten Ergebnis, da man erwarten würde, dass die Zuverlässigkeit der kodierten Bits zu den Enden hin stetig zunimmt. Es zeigt sich aber bei genauer Betrachtung der Polynome für den verwendeten Faltungskodierer, dass diese Annahme überraschenderweise nicht stimmt. Durch die spezifischen Eigenschaften der Polynome ergeben sich, insbesondere am Ende, kodierte Bits, die weniger effektiv zur Kodierung beitragen. Diese Bits treten aber nicht zum Ende hin in stetig zunehmendem Maße auf, sondern sind etwas unregelmäßig verteilt. Indem man das Punktierungsmuster speziell auf diese "schwachen" Bits hin ausrichtet, also bevorzugt diese Bits punktiert, kann man die Kodierung noch weiter verbessern.

Die Erfindung bedient sich also eines heuristisches Verfahrens, das erlaubt:

- mittels einer neu definierten, heuristischen Metrik die Auswirkung der Punktierung / Repetierung eines codierten Bits auf die zugrunde liegenden Informationsbits näherungsweise zu ermitteln,
- gezielt und für jeden Faltungscode spezifisch Bits auszuwählen, die punktiert bzw. repetiert werden sollen,
- die Anzahl der zu untersuchenden Ratenanpassungsmuster stark einzuschränken.

Nachdem, basierend auf diesem Verfahren, einige wenige erfolgversprechende Ratenanpassungsmuster ermittelt worden sind, werden diese anhand der Rahmenfehlerrate und der Bit fehlerrate jedes einzelnen Informationsbits (im Folgenden als Bitfehlerratenverteilung bezeichnet) verglichen. Iterativ kann dann, basierend auf der entwickelten Metrik, das Ratenanpassungsmuster weiter verfeinert und optimiert werden. Als Startinformation dient die Bitfehlerratenverteilung des unpunktierten / nicht-repetierten Blocks

Als heuristische Metrik wird die Punktierungsstärke $S_i$ pro Bit Informationsbit $i$ definiert als die Anzahl der durch die Punktierung nicht übertragenen Verknüpfungen eines Informationsbits mit den jweiligen Ausgangsbits des Encoders. $S_i$ ist daher für Punktierung positiv. Für Repetierung wird für jede $n$-fach übertragene Verknüpfung $S_{i,k} = n$-1 definiert.

$S_{max}$ ist die maximal mögliche Punktierungsstärke, gegeben durch die codespezifische Gesamtzahl der bestehenden Verknüpfungen:

Ein gutes Ratenanpassungsmuster wird nach folgenden. Gütekriterien gesucht:

1.Wähle die kumulative Punktierungsstärke nahe beim möglichen Minimum
2. Sorge für eine möglichst gleichverteilte Bitfehlerrate über allen Informationsbits

Für die Auswahl der zu punktierenden/repetierenden Bits werden basierend auf den Generatorpolynomen des Codes, für den Anfang und das Ende des kodierten Blocks Tabellen aufgestellt, welche die kumulative Punktierungsstärke pro codiertem Bit, sowie die betroffenen Informationsbits darstellen. Damit lassen sich die codierten Bits in sog. Klassen der kumulativen Punktierungsstärke einteilen.

Nach dem obigen Gütekriterium werde nun anhand dieser Tabellen zu punktierende / zu repetierende Bits so ausgesucht, dass zunächst für diejenigen Informationsbits, die eine niedrigere Bitfehlerrate zeigen als andere Bits, die Punktierungsstärke erhöht wird und gleichzeitig die kumulative Punktierungsstärke gering gehalten wird. Die Punktierungsstärke wird also umgekehrt proportional zur Bitfehlerrate des Informationsbits gewählt und zudem werden gezielt Bits ausgesucht, die wenig zur kumulativen Punktierungsstärke beitragen.

Dieses Verfahren wird danach, basierend auf dem ersten ermittelten Muster iterativ angewendet, so dass schon nach wenigen Simulationen ein für den jeweiligen Faltungscode spezifisch optimiertes Ratenanpassungspattern gefunden werden kann .

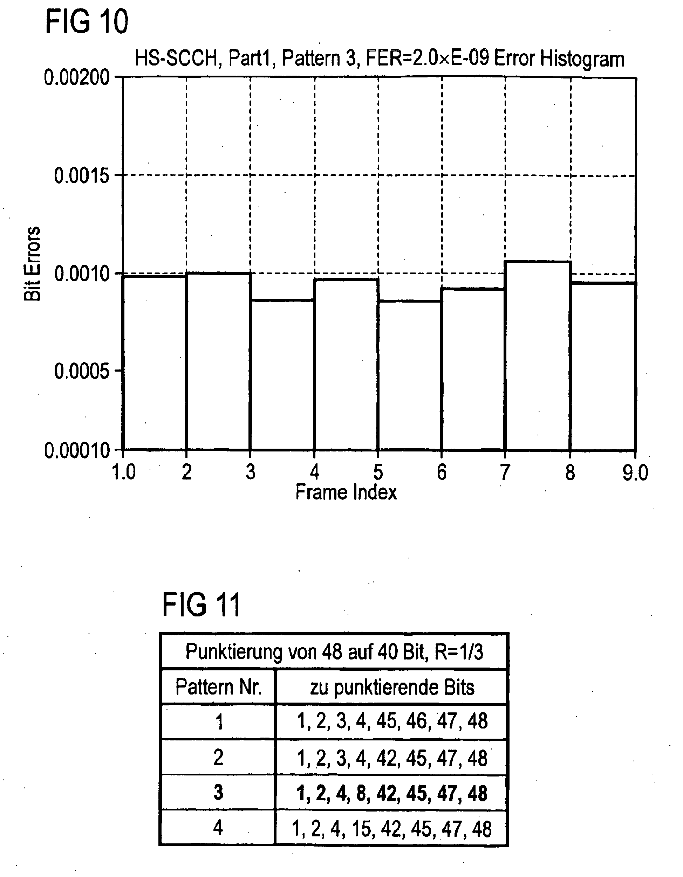

Im den Fig. 11 und 12 sind verschiedene Möglichkeiten für erfindungsgemäße Punktierungsmuster dargestellt, wobei jeweils die Nummern der zu punktierenden Bits (die Zählung beginnt bei 1) angegeben sind. Die Tabellen sind für unterschiedliche Anzahlen von zu übertragenden Informationsbits und unterschiedliche Anzahlen von nach der Ratenanpassung zu übertragende Bits angegeben.

In Fig. 3 ist beispielhaft der Verlauf der Bitfehlerrate für die einzelnen übertragenen Bits eines Datenblocks in Abhängigkeit von ihrer Position oder Lage in dem Datenblock für eine herkömmliche Punktierung mit einem regelmäßigen Punktierungsmuster aufgetragen.

In Fig. 2 ist dieser Verlauf für eine erfindungsgemäße Punktierung mit dem Muster Nummer 33 aus Fig. 12, welches sich in Simulationen als besonders geeignet herausgestellt hat, gezeigt. Aus Fig. 2 ist ersichtlich, dass durch Verwendung des erfindungsgemäßen Punktierungsmusters, ein gleichmäßigerer Verlauf der Bitfehlerrate über den gesamten Datenblock erzielt werden kann. Da im mittleren Bereich des Datenblocks gegenüber der herkömmlichen Vorgehensweise weniger häufig punktiert wird, kann dort eine geringere Fehlerwahrscheinlichkeit erhalten werden. Tatsächlich steigt die Fehlerrate nun zu den Enden hin etwas an, was auf den ersten Blick ungünstig erscheinen könnte. Das resultiert aber daher, dass am Rand besonders viele "schwache" Bits sind, wie bereits oben ausgeführt, wo eine Punktierung recht günstig durchgeführt werden kann.

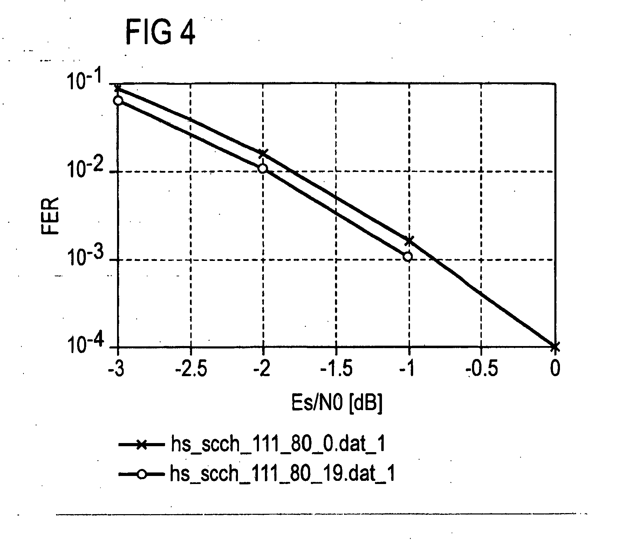

In Fig. 4 ist für dieselben Fälle der Verlauf der Gesamtfehlerrate über den Verhältnis der Energie der übertragenen Bits zur Rauschleistungdichte aufgetragen. Aus Fig. 4 ist ersichtlich, dass mit Hilfe der Erfindung (untere Kurve, Kreise) eine gegenüber der herkömmlichen Vorgehensweise (obere Kurve, Kreuze) eine um ca. 0,2dB verbesserte Rahmenfehlerrate erzielt werden kann.

Ähnliche Verbesserungen lassen sich auch bei anderen Parametern erzielen. Beispielsweise zeigt die Fig. 6 den Verlauf der Bitfehlerrate für die einzelnen übertragenen Bits eines Datenblocks in Abhängigkeit von ihrer Position in dem Datenblock für eine herkömmliche Punktierung mit einem regelmäßigen Punktierungsmuster bei einer Kodierung mit Rate 1/3 und einer Punktierung von 8 Bit (48 auf 40 Bit). Das entspricht einer Übertragung von 8 Input Bits. Fig. 10 zeigt die Verteilung, wenn statt dessen das Punktierungsmuster Nr. 3 aus Fig. 11 verwendet wird, welches sich in Simulationen ebenfalls als besonders geeignet herausgestellt hat. Man sieht, dass sich hier eine sehr ausgeglichene Verteilung ergibt. Auch hierbei ergibt sich eine Verbesserung um ca. 0,2dB (hierfür ist aber keine Kurve angefügt, da sie nicht weitere wesentliche Erkenntnisse bringt).

Die Figur 16 zeigt weitere bevorzugte Ausführungsbeispiele im Rahmen der Erfindung mit einer Punktierung von 14 von 54 Bits, wobei die Muster 3 und 4 die besten Ergebnisse erzielen.

Die Figuren 13, 14 und '15 zeigen bevorzugte Repetierungsmuster, welche auch durch Anwendung der in dieser Erfindung gezeigten Regeln gewonnen wurden.

Die vorliegende Erfindung wurde bisher anhand der Verwendung in einem Mobilfunksender beschrieben. Selbstverständlich kann die Erfindung jedoch auch auf Mobilfunkempfänger ausgedehnt werden, wo ein zur Anpassung der Datenrate auf oben beschriebene Art und Weise punktiertes bzw. repetiertes Signal entsprechend dem jeweils verwendeten Punktierungs- bzw. Repetierungsmuster aufgearbeitet werden muss. Dabei werden in dem jeweiligen Empfänger für sendeseitig punktierte bzw. repetierte Bits zusätzliche Bits in den Empfangs-Bitstrom eingefügt bzw. zwei oder mehr Bits des Empfangs-Bitstroms zusammengefasst. Bei Einfügen von zusätzlichen Bits wird für diese gleichzeitig in Form einer sogenannten 'Soft Decision'-Information vermerkt, dass ihr Informationsgehalt sehr unsicher ist. Die Verarbeitung des Empfangssignals kann in dem jeweiligen Empfänger sinngemäß in umgekehrter Reihenfolge zu Fig. 1 erfolgen.

## Weitere unter Verwendung des oben erläuterten Vorgehens ermittelte Ratenanpassungsmuster

Die bisher angegebene Punktierungsmuster konzentrieren sich überwiegend auf eine Punktierung in den Endbereichen oder/und eine Repetierung im mittleren Bereich.

Die nun beschriebenen weiteren Ratenanpassungsmuster wurden mit dem in dem vorher erläuterten Verfahren für verschiedene Vorschläge zur HS-SCCH Codierung in der Standardisierung ermittelt. Angegeben sind jeweils die zu punktierenden bzw. zu repetierenden Bits. Die Bits werden von 1 bis N durchnummeriert. Das bevorzugte Muster wird jeweils zuerst genannt, die weiteren Muster weisen aber stets ähnlich günstige Eigenschaften auf.

Die Figur 17, in der diese weiteren Punktierungsmuster aufgeführt sind, stellt also eine Ergänzung zur Figur 12 dar. Entsprechend sind in den Figuren 18- 24 Punktierungsmuster für verschiedene Ausgangsbitraten dargestellt und in Fig. 25 weitere Repetierungsmuster.

## Approximation von bevorzugten Ratenanpassungsmustern unter Verwendung von bereits in UMTS spezifizeirter Komponenten.

Die bisher gezeigten Muster haben das Ziel, eine möglichst optimale Auswahl von zu punktierenden bzw. zu repetierenden Bits vorzuschlagen, wobei ansonsten keine weiteren Einschränkungen bezüglich der Muster vorausgesetzt werden. In praktischen Implementierungen kann es aber vorteilhaft sein, nur solche Muster zu betrachten, welche sich mit möglichst kleinen Änderungen an bestehenden Ratenanpassungsschaltungen implementieren lassen. Eine entsprechende

Ratenanpassungsvorschrift ist in der bereits erwähnten Spezifikation 25.212 v5.0.0, Kap. 4.2.7 "Rate matching" (Ratenanpassung) beschrieben. Im folgenden wird der Teil dieser Vorschrift, der die eigentliche Punktierung oder Repetierung vornimmt und im Kapitel 4.2.7.5 "Rate matching pattern determination" (Bestimmung von Mustern zur Ratenanpassung) beschrieben ist, sinngemäß wiedergegeben. Auszug aus der Spezifikation:

Vor der Ratenanpassung werden die Bits mit $x_{i1},x_{i2},x_{i3},...,x_{iX_1}$ gekennzeichnet. Hierbei stellt i die Transportkanal Nummer dar, die Sequenz selbst ist in den Abschnitten 4.2.7.4 der Spezifikation für den Uplink und in 4.2.7.1. für den Downlink definiert. Als Uplink wird die Verbindung eines Kommunikationsgeräts zur Basisstation verstanden, als Downlink die Verbindung einer Basisstation zu einem Kommunikationsgerät.

Die Regel zur Ratenanpassung ist in dem in Fig. ??? gezeigten Programmausschnitt wiedergegeben, welcher bei Erfüllen der Bedingung abläuft, dass eine Punktierung durchgeführt wird.

- Es wird zunächst eine Fehlerwert e auf einen Anfangswert gesetzt welcher zwischen dem ursprünglichen Fehlerwert und der gewünschten Punktierungsrate liegt.
- In einer Schleife mit dem Index m des momentan betrachteten Bits als Laufparameter wird bis zum Ende der Sequenz, also bis zum Index $X_i$

- Zunächst der Fehlerwert e auf e - e$_{minus}$ gesetzt, wobei e$_{minus}$ im Wesentlichen die Anzahl der zu punktierenden Bits darstellt.
- Anschliessend wird überprüft, ob der Fehlerwert e <= 0 ist

  - In diesem Falle wird überprüft, ob das Bit mit dem Index m punktiert werden soll, wobei ein zu punktierendes Bit dann auf einen Wert $\delta$ gesetzt wird, der verschieden von 0 oder 1 ist.

Im Falle dass eine dass eine Repetierung stattfinden soll, findet ein im Wesentlichen analoger Vorgang statt, wobei dann ein repetiertes Bit direkt hinter das ursprüngliche Bit gesetzt wird.

Bit

Bei einer Punktierung werden dann im weiteren Verlauf dann die Bits die auf den Wert $\delta$ gesetzt wurden entfernt, so dass diese Bits also punktiert werden.

Die Parameter $X_i$, e$_{ini}$, e$_{plus}$, und e$_{minus}$ werden jeweils so gewählt, dass die gewünschte Ratenanpassung zu erzielt werden kann. Es gilt dann im Wesentlichen $e_{plus} = X_i$, $e_{minus} = N_p$, wobei $X_i$, die Anzahl der Bits vor der Ratenanpassung bezeichnet und $N_p$ die Anzahl der zu punktierenden bzw. repetierenden Bits. e$_{ini}$ kann im Bereich zwischen 1 und e$_{plus}$ im Prinzip beliebig gewählt werden, wobei sich eine leichte Verschiebung des Musters ergibt, dies wird in gewissen Fällen (Ratenanpassung nach einem ersten Interleaving (Verschachteln)) verwendet, um die Muster in verschiedenen Rahmen geeignet gegeneinander zu verschieben. Der Parameter i kennzeichnet in der Spezifikation unterschiedliche Transportkanäle. Dieser Parameter ist aber im vorliegenden Fall irrelevant wird daher weggelassen. Nachfolgend werden Möglichkeiten gezeigt, wie man mittels diesem bereits vorhandenen Rate Matching Algorithmus bevorzugte Ratenanpassungsmuster für kurze Blockgrößen bei Faltungscodes approximieren kann. Dabei wird unter der Randbedingung dieses Algorithmus versucht, bei Punktierung bevorzugt Bits an den Enden des Codeblocks zu verwenden und bei Repetierung vor allem Bits aus der Mitte des Codeblocks. Ein Kernaspekt dieses Ausführungsbeispiels besteht darin, den Parameter e$_{ini}$ nicht auf den Wertebereich von 1 bis e$_{plus}$ zu beschränken, sondern statt dessen in vorteilhafter Weise außerhalb dieses Bereiches zu wählen. Eine solche Wahl mag auf den ersten Blick widersinnig erscheinen, weil dann nicht mehr sichergestellt ist, dass die gewünschte Anzahl von Bits punktiert bzw. repetiert wird. Durch eine vorteilhafte

Anpassung der Werte von e$_{plus}$ und e$_{minus}$ kann aber erzielt werden, dass dennoch die gewünschte Anzahl erreicht wird.

Es sei:

$X_i$: Anzahl der Bits vor Rate Matching

$N_p$: Anzahl zu punktierender / repetierender Bits (der Index p in $N_p$ weist auf die Anzahl der zu punktierenden Bits hin, $N_p$ kann aber auch die Anzahl der zu repetierenden Bits bezeichnen)

Um die Anwendung des Rate Matching Algorithmus und damit die Ratenanpassungsmuster vollständig zu spezifizieren, müssen jeweils der Fehleranfangswert $e_{ini}$, das Fehlerinkrement $e_{plus}$ und das Fehlerdekrement $e_{minus}$ angegeben werden, da diese Parameter das Ratenanpassungsmuster vollständig beschreiben.

Im folgenden wird die Approximation von bevorzugten Ratenanpassungsmustern mittels dem im Release 99 UMTS Rate-Matching aufgeführten Algorithmus dargestellt.

Nachfolgend werden Möglichkeiten gezeigt, wie mittels des bereits im Standard vorhandenen Rate Matching Algorithmus (Datenraten-Anpassungsalgorithmus) bevorzugte Ratenanpassungsmuster für kurze Blockgrößen bei Faltungscodes approximiert werden können. Dabei wird unter der Randbedingung dieses Algorithmus versucht, bei Punktierung bevorzugt Bits an den Enden des Codeblocks zu verwenden und bei Repetierung vor allem Bits aus der Mitte des Codeblocks.

**Punktierung**

Die Parameter des Rate Matching Algorithmus werden so gewählt, dass die ersten $N_0$ Bits am Beginn des Codeblock punktiert werden, dazu muss gelten

$$N_0 \cdot \left(e_{minus} - e_{plus}\right) < e_{ini} \leq N_0 \cdot e_{minus} - \left(N_0 - 1\right) \cdot e_{plus} \quad (1)$$

Als weiteres Kriterium ist vorgesehen, dass auch das letzte Bit des Blocks punktiert wird, und zwar gemäß folgender Bedingung:

$$(N_0 - 1) \cdot (e_{minus} - e_{plus}) < e_{ini} \quad (2)$$

In diesem Fall wird nämlich der Wert der Fehlervariablem e genau beim letzten Bit negativ werden, was bedingt, dass dann dieses Bit punktiert wird.

Beide Kriterien werden z. B. durch folgende bevorzugte Wahl der Parameter erfüllt:

$$e_{plus} = X_i - N_0 \quad (3)$$

$$e_{minus} = N_p - N_0 \quad (4)$$

$$e_{ini} = N_0 \cdot e_{minus} - (N_0 - 1) \cdot e_{plus} \quad (5)$$

In diesen Formeln ist auch der Spezialfall, dass kein Bit am Beginn des Codeblocks punktiert werden soll ($N_0$ = 0), enthalten. Es gilt dann: $e_{ini} = X_i$, $e_{plus} = X_i$, $e_{minus} = N_p$.

Die allgemeinen Implementierungen, welche $e_{ini}$ nach den Formeln (1) bis (4) wählen, ergeben Ratenanpassungsmuster, welche sich von denjenigen der bevorzugten Parameterwahl nach (3) bis (5) lediglich dadurch unterscheiden, dass von der ($N_0$ + 1)-ten bis zur ($N_p$ - 1)-ten Punktierungsstelle der Index des zu punktierenden Bits um eins erniedrigt sein kann.

Für das Anwendungsbeispiel einer Punktierung von 48 Bit auf 40 Bit zeigt die Tabelle in Fig. 26 Punktierungsmuster nach der bevorzugten Parameterwahl bis zu $N_0$ = 6. Die nicht fett gedruckten Punktierungsstellen können durch Variation des $e_{ini}$ Wertes gemäß (1) und (2) entweder teilweise oder vollständig um eins erniedrigt werden.

Die nachfolgend in Fig. 27 dargestellte Tabelle zeigt in gleicher Weise die resultierenden Muster für eine Punktierung von 111 Bit auf 80 Bit.

Obwohl sich auf diese Weise nicht die optimalen Punktierungsmuster, die bereits weiter oben besprochen wurden, erzielen lassen, so kann man mit diesem Verfahren doch eine gewisse Verbesserung der Übertragungsqualität gegenüber dem derzeitigen Stand der Spezifikation erreicht werden, wobei die vorzunehmenden Änderungen vergleichsweise gering sind.

**Repetierung**

Die Parameter des Rate Matching Algorithmus werden erfindungsgemäß so berechnet, dass ein maximaler Abstand des letzten zu repetierenden Bits vom Blockende garantiert wird, es muss also gelten:

$$e_{ini} = 1 + X_i \cdot e_{minus} - N_p \cdot e_{plus} \quad . \quad (6)$$

Weiterhin kann der mittleren Abstand zwischen zu repetierenden Bits $R_R$ vorgegeben werden. $R_R$ muss nicht eine ganze Zahl sein, sondern kann eine positive rationale Zahl sein. Es gilt dann:

$$R_R = \frac{e_{plus}}{e_{minus}} , \quad (7)$$

Somit können $e_{plus}$ und $e_{minus}$ unter der Randbedingung, dass ihr Quotient gerade $R_R$ ergibt und insgesamt $N_p$ Bits repetiert werden, frei gewählt werden.

Soll das erste zu repetierende Bit, genauer gesagt die Position des ersten zu repetierenden Bits (hier als $b_1$ bezeichnet) vorgegeben werden, so muss neben (6) gelten

$$\frac{e_{ini}}{b_1} \le e_{minus} < \frac{e_{ini}}{b_1 - 1} , \qquad (8)$$

wobei $e_{minus}$ eine Ganzzahl sein sollte und $b_1 \le X_i - N_p + 1$. Eine bevorzugte Parameterwahl ergibt für

$$e_{minus} = N_p . \qquad (9)$$

$$e_{plus} = X_i - b_1 + 1 \qquad (10)$$

$$e_{ini} = (b_1 - 1) \cdot N_p + 1 \qquad (11)$$

Mit dieser Wahl der Parameter ist die Position des ersten zu repetierenden Bits $b_1$, und es werden, wie gefordert, $N_p$ Bits repetiert.

Auch hier sind die entstehenden Repetierungsmuster nicht optimal, verglichen mit den bereits weiter oben besprochen Mustern. Trotzdem kann man mit diesem Verfahren doch eine gewisse Verbesserung der Übertragungsqualität gegenüber dem derzeitigen Stand der Spezifikation erreicht werden, wobei die vorzunehmenden Änderungen wiederum vergleichsweise gering sind. Durch eine günstige Wahl des Parameters b$_1$ kann erreicht werden, dass die Repetierung nicht schon am Anfang beginnt. Am Anfang ist eine Repetierung nämlich nicht nötig, da die Bits am Anfang des Faltungsdecoders wie oben gezeigt ohnehin schon eine vergleichsweise niedrige Fehlerrate aufweisen. Viel nutzbringender ist es also, wenn die zu repetierenden Bits, wie durch dieses Verfahren geschehen eher zur Mitte hin konzentriert werden. Ein Nachteil dieses Ausführungsbeispiels ist allerdings, dass es nur am Anfang Repetierung vermeidet, während die Verhältnisse am Ende weit weniger positiv beeinflusst werden können. Das ist der Preis, der für die vereinfachte Implementierung gezahlt werden muss.

Selbstverständlich ist auch eine Kombination von oben genannten Kriterien bei der Auswahl eines Punktierungsmusters möglich. Beispielsweise kann man ein Muster aus zwei hier vorgestellten Mustern kombinieren, indem am Anfang der Anfang des einen Musters verwendet wird und am Ende das Ende des zweiten Musters. Des weiteren ist es unerheblich, wenn die Bits in einer veränderten Reihenfolge ausgegeben werden, und gleichzeitig das Punktierungsmuster analog angepasst wird. Beispielsweise kann man die Reihenfolge der Polynome im Faltungskodierer vertauschen.

**Patentansprüche**

**1.** Verfahren zur Anpassung der Datenrate eines Datenstroms in einer Kommunikationsvorrichtung,

- wobei der Datenstrom in zumindest einen Datenblock unterteilbar ist, welcher zu übertragende Übertragungsbits enthält,
- wobei die Übertragungsbits durch einen Codiervorgang der Rate 1/3 aus Information tragenden Eingangsbits gebildet werden,
- bei dem zur Anpassung der Datenrate aus einem Datenblock des Datenstroms bestimmte Übertragungsbits entfernt werden,
- wobei durch ein Punktierungsmuster vorgegeben wird, welche Übertragungsbits zu entfernen sind,
**dadurch gekennzeichnet,**
**dass** das Punktierungsmuster derart ausgestaltet ist, dass 8 von 48 Bits des Datenblocks punktiert werden, und zwar die Bits 1, 2, 4, 8, 42, 45, 47 und 48.

**2.** Verfahren zur Anpassung der Datenrate eines Datenstroms in einer Kommunikationsvorrichtung,

- wobei der Datenstrom in zumindest einen Datenblock unterteilbar ist, welcher zu übertragende Übertragungsbits enthält,
- wobei die Übertragungsbits durch einen Codiervorgang der Rate 1/3 aus Information tragenden Eingangsbits gebildet werden,
- bei dem zur Anpassung der Datenrate aus einem Datenblock des Datenstroms bestimmte Übertragungsbits entfernt werden,
- wobei durch ein Punktierungsmuster vorgegeben wird, welche Übertragungsbits zu entfernen sind,
**dadurch gekennzeichnet,**
**dass** das Punktierungsmuster derart ausgestaltet ist, dass 31 von 111 Bits des Datenblocks punktiert werden, und zwar die Bits 1, 2, 3, 4, 5, 6, 7, 8, 12, 14, 15, 24, 42, 48, 54, 57, 60, 66, 69, 96, 99, 101, 102, 104, 105, 106, 107, 108, 109, 110 und 111.

3. Verfahren nach einem der vorhergehenden Ansprüche, **dadurch gekennzeichnet, dass** die zu übertragenden Übertragungsbits über den HS-SCCH gemäß dem UMTS-Standard übertragen werden.

4. Kommunikationsvorrichtung zur Anpassung der Datenrate eines Datenstroms, die eine Ratenanpassungseinrichtung (6) zur Punktierung oder Aufarbeitung eines Datenblocks gemäß einem bestimmten Ratenanpassungsmuster aufweist, wobei der aus dem der Ratenanpassungseinrichtung (6) zugeführten Datenstrom durch Unterteilung gebildete Datenblock zu übertragende, durch einen Codiervorgang mit der Rate 1/3 aus Information tragenden Eingangsbits gebildete Übertragungsbits enthält und wobei die Ratenanpassungseinrichtung durch die Punktierung dem Ratenanpassungsmuster entsprechende Bits aus dem Datenblock entfernt oder den punktierten Datenblock entsprechend einem jeweils verwendeten Punktierungsmuster aufarbeitet, **dadurch gekennzeichnet,**
**dass** die Ratenanpassungseinrichtung (6) derart ausgestaltet ist, dass die Ratenanpassung mit einem Punktierungsmuster erfolgt, welches 8 von 48 Bits des Datenblocks punktiert, und zwar die Bits 1, 2, 4, 8, 42, 45, 47 und 48.

5. Kommunikationsvorrichtung zur Anpassung der Datenrate eines Datenstroms, die eine Ratenanpassungseinrichtung (6) zur Punktierung oder Aufarbeitung eines Datenblocks gemäß einem bestimmten Ratenanpassungsmuster aufweist, wobei der aus dem der Ratenanpassungseinrichtung (6) zugeführten Datenstrom durch Unterteilung gebildete Datenblock zu übertragende, durch einen Codiervorgang mit der Rate 1/3 aus Information tragenden Eingangsbits gebildete Übertragungsbits enthält und wobei die Ratenanpassungseinrichtung durch die Punktierung dem Ratenanpassungsmuster entsprechende Bits aus dem Datenblock entfernt oder den punktierten Datenblock entsprechende einem jeweils verwendeten Punktierungsmuster aufarbeitet, **dadurch gekennzeichnet,**
**dass** die Ratenanpassungseinrichtung (6) derart ausgestaltet ist, dass die Ratenanpassung mit einem Punktierungsmuster erfolgt, welches 31 von 111 Bits des Datenblocks punktiert, und zwar die Bits 1, 2, 3, 4, 5, 6, 7, 8, 12, 14, 15, 24, 42, 48, 54, 57, 60, 66, 69, 96, 99, 101, 102, 104, 105, 106, 107, 108, 109, 110 und 111.

6. Kommunikationsvorrichtung nach Anspruch 4 oder 5,
**dadurch gekennzeichnet,**
**dass** die Kommunikationsvorrichtung (1) eine Mobilfunksende- oder Mobilfunkempfangsvorrichtung ist wobei in der Mobilfunksendevorrichtung die Ratenanpassungseinrichtung die Bits des Datenblocks gemäß dem Punktierungsmuster punktiert und in der Mobilfunkempfangsvorrichtung die Ratenanpassungseinrichtung den punktierten Datenblock gemäß dem Punktierungsmuster aufarbeitet.

## Claims

1. Method for adapting the data transfer rate of a data stream in a communications device,

- wherein the data stream is able to be subdivided into at least one data block which contains transmission bits to be transmitted,
- wherein the transmission bits are formed by a coding process of the rate 1/3 from input bits bearing information,
- in which, to adapt the data transfer rate, specific transmission bits are removed from a data block of the data stream,
- wherein the transmission bits which are to be removed are predetermined by a puncturing pattern,
**characterised in**
**that** the puncturing pattern is designed such that 8 of 48 bits of the data block are punctured, and these are bits 1, 2, 4, 8, 42, 45, 47 and 48.

2. Method for adapting the data transfer rate of a data stream in a communications device,

- wherein the data stream is able to be subdivided into at least one data block which contains transmission bits to be transmitted,
- wherein the transmission bits are formed by a coding process of the rate 1/3 from input bits bearing information,
- in which, to adapt the data transfer rate, specific transmission bits are removed from a data block of the data stream,
- wherein the transmission bits which are to be removed are predetermined by a puncturing pattern,
**characterised in**
**that** the puncturing pattern is designed such that 31 of 111 bits of the data block are punctured, and these are bits 1, 2, 3, 4, 5, 6, 7, 8, 12, 14, 15, 24, 42, 48, 54, 57, 60, 66, 69, 96, 99, 101, 102, 104, 105, 106, 107, 108, 109, 110 and 111.

3. Method according to one of the preceding claims,
**characterised in that** the data transfer bits to be transmitted are transmitted via the HS-SCCH in accordance with the UMTS standard.

4. Communications device for adapting the data transfer rate of a data stream, having
a rate adaptation device (6) for puncturing or processing a data block in accordance with a specific rate adaptation pattern, wherein the data block formed by subdivision from the data stream supplied to the rate adaptation device (6) contains transmission bits formed by a coding process with the rate 1/3 from input bits bearing information and wherein the rate adaptation device removes corresponding bits from the data block by puncturing from the rate adaptation pattern or processes the punctured data block in accordance with a puncture pattern used in each case,
**characterised in**
**that** the rate adaptation device (6) is embodied such that rate adaptation is carried out with a puncture pattern which punctures 8 of 48 bits of the data block, and these are bits 1, 2, 4, 8, 42, 45, 47 and 48.

5. Communications device for adapting the data transfer rate of a data stream,
having a rate adaptation device (6) for puncturing or processing a data block in accordance with a specific rate adaptation pattern, wherein the data block formed by subdivision from the data stream supplied to the rate adaptation device (6) contains transmission bits formed by a coding process with the rate 1/3 from input bits bearing information and wherein the rate adaptation device removes corresponding bits from the data block by puncturing the rate adaptation pattern or processes the punctured data block in accordance with a puncture pattern used in each case,
**characterised in**
**that** the rate adaptation device (6) is embodied such that rate adaptation is carried out with a puncture pattern which punctures 31 of 111 bits of the data block, and these are bits 1, 2, 3, 4, 5, 6, 7, 8, 12, 14, 15, 24, 42, 48, 54, 57, 60, 66, 69, 96, 99, 101, 102, 104, 105, 106, 107, 108, 109, 110 and 111.

6. Communications device according to claim 4 or 5,
**characterised in**
**that** the communications device (1) is a mobile radio transmission or mobile radio receiving device, wherein, in the mobile radio transmission device, the rate adaptation device punctures the bits of the data block according to the puncturing pattern and in the mobile radio receiving device the rate adaptation device processes the punctured data block according to the puncturing pattern.

**Revendications**

1. Procédé d'adaptation du débit de données d'un flux de données dans un dispositif de communication,

- le flux de données pouvant être subdivisé en au moins un bloc de données qui contient des bits de transmission à transmettre,
- les bits de transmission étant formés par une opération de codage du débit 1/3 à partir de bits d'entrée porteurs d'information,
- selon lequel certains bits de transmission sont supprimés d'un bloc de données du flux de données en vue de l'adaptation du débit de données,

- un modèle de poinçonnage spécifiant quels sont les bits de transmission à supprimer,
**caractérisé en ce que** le modèle de poinçonnage est réalisé de manière telle que, sur 48 bits du bloc de données, 8 sont poinçonnés, à savoir les bits 1, 2, 4, 8, 42, 45, 47 et 48.

2.  Procédé d'adaptation du débit de données d'un flux de données dans un dispositif de communication,

    - le flux de données pouvant être subdivisé en au moins un bloc de données qui contient des bits de transmission à transmettre,
    - les bits de transmission étant formés par une opération de codage du débit 1/3 à partir de bits d'entrée porteurs d'information,
    - selon lequel certains bits de transmission sont supprimés d'un bloc de données du flux de données en vue de l'adaptation du débit de données,
    - un modèle de poinçonnage spécifiant quels sont les bits de transmission à supprimer,
    **caractérisé en ce que** le modèle de poinçonnage est réalisé de manière telle que, sur 111 bits du bloc de données, 31 sont poinçonnés, à savoir les bits 1, 2, 3, 4, 5, 6, 7, 8, 12, 14, 15, 24, 42, 48, 54, 57, 60, 66, 69, 96, 99, 101, 102, 104, 105, 106, 107, 108, 109, 110 et 111.

3.  Procédé selon l'une des revendications précédentes, **caractérisé en ce que** les bits de transmission à transmettre sont transmis sur le HS-SCCH selon la norme UMTS.

4.  Dispositif de communication pour adapter le débit de données d'un flux de données, lequel dispositif comporte un dispositif d'adaptation de débit (6) pour poinçonner ou traiter un bloc de données selon un modèle déterminé d'adaptation de débit, le bloc de données formé par subdivision à partir du flux de données amené au dispositif d'adaptation de débit (6) contenant des bits de transmission à transmettre formés par une opération de codage avec le débit 1/3 à partir de bits d'entrée porteurs d'information, et le dispositif d'adaptation de débit supprimant du bloc de données, par le poinçonnage, des bits correspondant au modèle d'adaptation de débit ou traitant, selon un modèle de poinçonnage respectivement utilisé, le bloc de données poinçonné,
    **caractérisé en ce que**
    le dispositif d'adaptation de débit (6) est réalisé de manière telle que l'adaptation de débit s'effectue avec un modèle de poinçonnage qui, sur 48 bits du bloc de données, en poinçonne 8, à savoir les bits 1, 2, 4, 8, 42, 45, 47 et 48.

5.  Dispositif de communication pour adapter le débit de données d'un flux de données, lequel dispositif comporte un dispositif d'adaptation de débit (6) pour poinçonner ou traiter un bloc de données selon un modèle déterminé d'adaptation de débit, le bloc de données formé par subdivision à partir du flux de données amené au dispositif d'adaptation de débit (6) contenant des bits de transmission à transmettre formés par une opération de codage avec le débit 1/3 à partir de bits d'entrée porteurs d'information, et le dispositif d'adaptation de débit supprimant du bloc de données, par le poinçonnage, des bits correspondant au modèle d'adaptation de débit ou traitant, selon un modèle de poinçonnage respectivement utilisé, le bloc de données poinçonné,
    **caractérisé en ce que**
    le dispositif d'adaptation de débit (6) est réalisé de manière telle que l'adaptation de débit s'effectue avec un modèle de poinçonnage qui, sur 111 bits du bloc de données, en poinçonne 31, à savoir les bits 1, 2, 3, 4, 5, 6, 7, 8, 12, 14, 15, 24, 42, 48, 54, 57, 60, 66, 69, 96, 99, 101, 102, 104, 105, 106, 107, 108, 109, 110 et 111.

6.  Dispositif de communication selon la revendication 4 ou 5, **caractérisé en ce que** le dispositif de communication (1) est un dispositif émetteur radio mobile ou récepteur radio mobile, le dispositif d'adaptation de débit poinçonnant les bits du bloc de données selon le modèle de poinçonnage dans le dispositif émetteur radio mobile et le dispositif d'adaptation de débit traitant, dans le dispositif récepteur radio mobile, selon le modèle de poinçonnage, le bloc de données poinçonné.

## FIG 1

```
   2                     3                      4
┌──────────────┐   ┌──────────────┐   ┌──────────────┐
│ Datenquelle  │──▶│ Quellcodierer│──▶│ Kanalcodierer│
└──────────────┘   └──────────────┘   └──────────────┘
                                               │
                                               ▼
                                       6a ┌──────────────┐
                                          │  Punktierung │
                                          └──────────────┘
                                               │
                                               ▼
                                       5  ┌──────────────┐
                                          │  Interleaver │
                                          └──────────────┘
                                               │
                                               ▼
                                       6b ┌────────────────┐
                                          │ Ratenanpassung │
                                          └────────────────┘
                                               │
                                               ▼
                                       7  ┌──────────────┐
                                          │  Modulator   │
                                          └──────────────┘
                                               │
                                               ▼
```

1

## FIG 2

HS-SCCH, Part 2, Pattern 19, FER=1.1×E-02 Error Histogram

## FIG 3

HS-SCCH, Part 2, Pattern 0, FER=1.6×E-02 Error Histogram

## FIG 4

Es/N0 [dB]

—✕— hs_scch_111_80_0.dat_1
—○— hs_scch_111_80_19.dat_1

## FIG 5

(a) Rate 1/2

Output 0
$G_0$=561 (octal)

Output 1
$G_1$=753 (octal)

(b) Rate 1/3

Output 0
$G_0$=557 (octal)

Output 1
$G_1$=663 (octal)

Output 2
$G_2$=711 (octal)

EP 1 497 943 B1

## FIG 6

HS-SCCH, Part1, Pattern 0, FER=2.8×E-03 Error Histogram

## FIG 7

Kumulatives Punktierungsniveau der kodierten Bits

## FIG 8

Betroffene Informationsbits

| Input Bit | Output 0 | Output 1 | Output 2 |
|---|---|---|---|
| 1 | 1 | 1 | 1 |
| 2 | 2 | 2, 1 | 2, 1 |
| 3 | 3, 1 | 3, 2 | 3, 2 1 |
| 4 | 4, 2, 1 | 4, 3, 1 | 4, 3, 2, |
| 5 | 5, 3, 2 | 5, 4, 2, 1 | 5, 4, 3, |
| 6 | 6, 4, 3, 1, | 6, 5, 3, 2 | 6, 5, 4, 1 |
| 7 | 7, 5, 4, 2, 1 | 7, 5, 4, 3 | 7, 6, 5, 2 |
| 8 | 8, 6, 5, 3, 2, 1 | 8, 6, 5, 4, 1 | 8, 7, 6, 3 |
| 9 | 9, 7, 6, 4, 3, 2, 1 | 9, 7, 6, 5, 2, 1 | 9, 8, 7, 4, 1 |

| Input Bit | Output 0 | Output 1 | Output 2 |
|---|---|---|---|
| n-8 | 0, -2, -3, -5, -6, -7, -8 | 0, -1, -3, -4, -7, -8 | 0, -1, -2, -5, -8 |
| n-7 | -1, -2, -4, -5, -6, -7 | 0, -2, -3, -6, -7 | 0, -1, -4, -7 |
| n-6 | 0, -1, -3, -4, -5, -6 | -1, -2, -5, -6 | 0, -3, -6 |
| n-5 | 0, -2, -3, -4, -5 | 0, -1, -4, -5 | -2, -5 |
| n-4 | -1, -2, -3, -4, | 0, -3, -4 | -1, -4 |
| n-3 | 0, -1, -2, -3 | -2, -3 | 0, -3 |
| n-2 | 0, -1, -2 | -1, -2 | -2 |
| n-1 | 0, -1 | 0, -1 | -1 |
| n | 0 | 0 | 0 |

EP 1 497 943 B1

EP 1 497 943 B1

Optimierte Punktierungsmuster

Punktierungssequenz und Kumulative Punktierung für max. 18 Eingangsbits

# FIG 9

| # punct bits | Sequenz | 1 | 2 | 3 | 4 | 5 | 6 | 7 | 8 | 9 | -8 | -7 | -6 | -5 | -4 | -3 | -2 | -1 | 0 | Mittelwert | Mittl. P-Rate | Kumulative |
|---|---|---|---|---|---|---|---|---|---|---|---|---|---|---|---|---|---|---|---|---|---|---|
| 1 | 1 | 1 | | | | | | | | | | | | | | | | | | 1,00 | 0,06 | 1 |
| 2 | k | 1 | | | | | | | | | | | | | | | | | 1 | 1,00 | 0,06 | 2 |
| 3 | 4 | 1 | 1 | | | | | | | | | | | | | | | | 1 | 1,00 | 0,06 | 3 |
| 4 | k-4 | 1 | 1 | | | | | | | | | | | | | | | 1 | 1 | 1,00 | 0,06 | 4 |
| 5 | k-6 | 1 | 1 | | | | | | | | | | | | | | 1 | 1 | 1 | 1,00 | 0,06 | 5 |
| 6 | 2 | 2 | 1 | | | | | | | | | | | | | | 1 | 1 | 1 | 1,20 | 0,07 | 6 |
| 7 | k-1 | 2 | 1 | | | | | | | | | | | | | | 1 | 1 | 2 | 1,40 | 0,08 | 7 |
| 8 | 3 | 3 | 1 | | | | | | | | | | | | | | 1 | 1 | 2 | 1,60 | 0,09 | 8 |
| 9 | k-2 | 3 | 1 | | | | | | | | | | | | | | 1 | 1 | 3 | 1,80 | 0,10 | 9 |
| 10 | 8 | 3 | 2 | 1 | | | | | | | | | | | | | 1 | 1 | 3 | 1,83 | 0,10 | 11 |
| 11 | k-15 | 3 | 2 | 1 | | | | | | | | | | | | | 2 | 1 | 3 | 1,86 | 0,10 | 13 |
| 12 | k-12 | 3 | 2 | 1 | | | | | | | | | | | 1 | 1 | 2 | 2 | 3 | 1,88 | 0,10 | 15 |
| 13 | k-10 | 3 | 2 | 1 | | | | | | | | | | 1 | 1 | 1 | 3 | 2 | 3 | 1,89 | 0,10 | 17 |
| 14 | 7 | 4 | 2 | 2 | | | | | | | | | | 1 | 1 | 1 | 3 | 2 | 3 | 2,11 | 0,12 | 19 |
| 15 | k-9 | 4 | 2 | 2 | | | | | | | | | | 1 | 1 | 2 | 3 | 2 | 4 | 2,33 | 0,13 | 21 |
| 16 | k-7 | 4 | 2 | 2 | | | | | | | | | | 1 | 1 | 2 | 4 | 3 | 4 | 2,56 | 0,14 | 23 |
| 17 | 5 | 5 | 3 | 2 | | | | | | | | | | 1 | 1 | 2 | 4 | 3 | 4 | 2,78 | 0,15 | 25 |
| 18 | k-4 | 5 | 3 | 2 | | | | | | | | | | 1 | 1 | 2 | 4 | 4 | 5 | 3,00 | 0,17 | 27 |
| 19 | 6 | 6 | 4 | 2 | | | | | | | | | | 1 | 1 | 2 | 4 | 4 | 5 | 3,22 | 0,18 | 29 |
| 20 | k-5 | 6 | 4 | 2 | | | | | | | | | | 1 | 1 | 2 | 4 | 5 | 6 | 3,44 | 0,19 | 31 |
| 21 | 15 | 6 | 4 | 3 | 1 | 1 | | | | | | | | 1 | 1 | 2 | 4 | 5 | 6 | 3,09 | 0,17 | 34 |
| 22 | 12 | 6 | 4 | 4 | 2 | 2 | | | | | | | | 1 | 1 | 2 | 4 | 5 | 6 | 3,36 | 0,19 | 37 |
| 23 | 14 | 6 | 5 | 5 | 2 | 3 | | | | | | | | 1 | 1 | 2 | 4 | 5 | 6 | 3,64 | 0,20 | 40 |
| 24 | k-18 | 6 | 5 | 5 | 2 | 3 | | | | | | | 1 | 1 | 1 | 3 | 4 | 5 | 7 | 3,58 | 0,20 | 43 |
| 25 | 11 | 7 | 5 | 6 | 3 | 2 | | | | | | | 1 | 1 | 1 | 3 | 4 | 5 | 7 | 3,75 | 0,21 | 45 |
| 26 | k-13 | 7 | 5 | 6 | 3 | 2 | | | | | | | 1 | 1 | 2 | 4 | 4 | 5 | 8 | 4,00 | 0,22 | 48 |
| 27 | 10 | 8 | 6 | 6 | 4 | 2 | | | | | | | 1 | 1 | 2 | 4 | 4 | 5 | 8 | 4,25 | 0,24 | 51 |
| 28 | k-8 | 8 | 6 | 6 | 4 | 2 | | | | | | | 1 | 1 | 2 | 4 | 5 | 6 | 9 | 4,50 | 0,25 | 54 |
| 29 | 9 | 9 | 7 | 7 | 4 | 2 | | | | | | | 1 | 1 | 2 | 4 | 5 | 6 | 9 | 4,75 | 0,26 | 57 |

## FIG 10

**HS-SCCH, Part1, Pattern 3, FER=2.0×E-09 Error Histogram**

## FIG 11

| Punktierung von 48 auf 40 Bit, R=1/3 | |
|---|---|
| Pattern Nr. | zu punktierende Bits |
| 1 | 1, 2, 3, 4, 45, 46, 47, 48 |
| 2 | 1, 2, 3, 4, 42, 45, 47, 48 |
| **3** | **1, 2, 4, 8, 42, 45, 47, 48** |
| 4 | 1, 2, 4, 15, 42, 45, 47, 48 |

## FIG 12A

| Punktierung von 111 auf 80 bit, R=1/3 | |
|---|---|
| Pattern | zu punktierende Bits |
| 1 | 1, 2, 3, 4, 5, 6, 7, 8, 9, 10, 11, 12, 14, 15, 24, 92, 93, 96, 98, 99, 101, 102, 103, 104, 105, 106, 107, 108, 109, 110, 111 |
| 2 | 1, 2, 3, 4, 5, 6, 7, 8, 9, 10, 11, 12, 13, 15, 24, 92, 93, 96, 98, 99, 101, 102, 103, 104, 105, 106, 107, 108, 109, 110, 111 |
| 3 | 1, 2, 3, 4, 5, 6, 7, 8, 9, 10, 11, 12, 14, 15, 48, 60, 93, 96, 98, 99, 101, 102, 103, 104, 105, 106, 107, 108, 109, 110, 111 |
| 4 | 1, 2, 3, 4, 5, 6, 7, 8, 9, 10, 11, 12, 13, 15, 48, 60, 93, 96, 98, 99, 101, 102, 103, 104, 105, 106, 107, 108, 109, 110, 111 |
| 5 | 1, 2, 3, 4, 5, 6, 7, 8, 10, 11, 12, 14, 15, 42, 45, 57, 66, 93, 96, 98, 99, 101, 102, 104, 105, 106, 107, 108, 109, 110, 111 |
| 6 | 1, 2, 3, 4, 5, 6, 7, 8, 10, 11, 12, 13, 15, 42, 45, 57, 66, 93, 96, 98, 99, 101, 102, 104, 105, 106, 107, 108, 109, 110, 111 |
| 7 | 1, 2, 3, 4, 7, 8, 9, 15, 21, 27, 33, 39, 45, 51, 57, 63, 69, 75, 81, 87, 93, 96, 99, 101, 102, 104, 105, 108, 109, 110, 111 |
| 8 | 1, 2, 3, 4, 5, 6, 7, 8, 11, 12, 14, 15, 24, 36, 48, 60, 72, 84, 93, 96, 99, 101, 102, 104, 105, 106, 107, 108, 109, 110, 111 |
| 9 | 1, 2, 3, 4, 5, 6, 7, 8, 11, 12, 13, 15, 24, 36, 48, 60, 72, 84, 93, 96, 99, 101, 102, 104, 105, 106, 107, 108, 109, 110, 111 |
| 10 | 1, 2, 3, 4, 5, 6, 7, 8, 11, 12, 14, 15, 27, 39, 51, 63, 75, 87, 93, 96, 99, 101, 102, 104, 105, 106, 107, 108, 109, 110, 111 |
| 11 | 1, 2, 3, 4, 5, 6, 7, 8, 11, 12, 13, 15, 27, 39, 51, 63, 75, 87, 93, 96, 99, 101, 102, 104, 105, 106, 107, 108, 109, 110, 111 |
| 12 | 1, 2, 3, 4, 5, 6, 7, 8, 10, 11, 12, 14, 15, 45, 48, 57, 63, 93, 96, 98, 99, 101, 102, 104, 105, 106, 107, 108, 109, 110, 111 |
| 13 | 1, 2, 3, 4, 5, 6, 7, 8, 10, 11, 12, 13, 15, 45, 48, 57, 63, 93, 96, 98, 99, 101, 102, 104, 105, 106, 107, 108, 109, 110, 111 |
| 14 | 1, 2, 3, 4, 5, 6, 7, 8, 11, 12, 14, 15, 24, 36, 48, 54, 60, 72, 84, 96, 99, 101, 102, 104, 105, 106, 107, 108, 109, 110, 111 |
| 15 | 1, 2, 3, 4, 5, 6, 7, 8, 11, 12, 13, 15, 24, 36, 48, 54, 60, 72, 84, 96, 99, 101, 102, 104, 105, 106, 107, 108, 109, 110, 111 |
| 16 | 1, 2, 3, 4, 5, 6, 7, 8, 10, 11, 12, 14, 15, 45, 48, 51, 57, 63, 93, 96, 99, 101, 102, 104, 105, 106, 107, 108, 109, 110, 111 |

## FIG 12B

| 17 | 1, 2, 3, 4, 5, 6, 7, 8, 10, 11, 12, 13, 15, 45, 48, 51, 57, 63, 93, 96, 99, 101, 102, 104, 105, 106, 107, 108, 109, 110, 111 |
|---|---|
| 18 | 1, 2, 3, 4, 5, 6, 7, 8, 12, 13, 15, 24, 36, 48, 54, 57, 60, 72, 84, 96, 99, 101, 102, 104, 105, 106, 107, 108, 109, 110, 111 |
| 19 | 1, 2, 3, 4, 5, 6, 7, 8, 12, 14, 15, 24, 36, 42, 48, 54, 57, 60, 72, 96, 99, 101, 102, 104, 105, 106, 107, 108, 109, 110, 111 |
| 20 | 1, 2, 3, 4, 5, 6, 7, 8, 12, 13, 15, 24, 36, 42, 48, 54, 57, 60, 72, 96, 99, 101, 102, 104, 105, 106, 107, 108, 109, 110, 111 |
| 21 | 1, 2, 3, 4, 5, 6, 7, 8, 12, 14, 15, 36, 42, 45, 48, 54, 57, 60, 72, 96, 99, 101, 102, 104, 105, 106, 107, 108, 109, 110, 111 |
| 22 | 1, 2, 3, 4, 5, 6, 7, 8, 12, 13, 15, 36, 42, 45, 48, 54, 57, 60, 72, 96, 99, 101, 102, 104, 105, 106, 107, 108, 109, 110, 111 |
| 23 | 1, 2, 3, 4, 5, 6, 7, 8, 12, 13, 15, 36, 42, 48, 51, 57, 60, 66, 72, 96, 99, 101, 102, 104, 105, 106, 107, 108, 109, 110, 111 |
| 24 | 1, 2, 3, 4, 5, 6, 7, 8, 12, 13, 15, 24, 36, 48, 54, 57, 60, 66, 72, 96, 99, 101, 102, 104, 105, 106, 107, 108, 109, 110, 111 |
| 25 | 1, 2, 3, 4, 5, 6, 7, 8, 12, 14, 15, 24, 48, 54, 57, 60, 63, 66, 72, 96, 99, 101, 102, 104, 105, 106, 107, 108, 109, 110, 111 |
| 26 | 1, 2, 3, 4, 5, 6, 7, 8, 12, 13, 15, 24, 48, 54, 57, 60, 63, 66, 72, 96, 99, 101, 102, 104, 105, 106, 107, 108, 109, 110, 111 |
| 27 | 1, 2, 3, 4, 5, 6, 7, 8, 13, 15, 24, 36, 42, 48, 51, 57, 60, 66, 72, 92, 96, 99, 101, 102, 104, 105, 107, 108, 109, 110, 111 |
| 28 | 1, 2, 3, 4, 5, 6, 7, 8, 12, 13, 15, 24, 42, 48, 54, 57, 60, 66, 69, 96, 99, 101, 102, 104, 105, 106, 107, 108, 109, 110, 111 |
| 29 | 1, 2, 3, 4, 5, 6, 7, 8, 9, 10, 11, 12, 14, 15, 24, 92, 93, 96, 98, 99, 101, 102, 103, 104, 105, 106, 107, 108, 109, 110, 111 |
| 30 | 1, 2, 3, 4, 5, 6, 7, 8, 9, 10, 11, 12, 13, 15, 24, 92, 93, 96, 98, 99, 101, 102, 103, 104, 105, 106, 107, 108, 109, 110, 111 |
| 31 | 1, 2, 3, 4, 5, 6, 7, 8, 10, 11, 12, 14, 15, 45, 48, 57, 66, 93, 96, 98, 99, 101, 102, 104, 105, 106, 107, 108, 109, 110, 111 |
| 32 | 1, 2, 3, 4, 5, 6, 7, 8, 10, 11, 12, 13, 15, 45, 48, 57, 66, 93, 96, 98, 99, 101, 102, 104, 105, 106, 107, 108, 109, 110, 111 |
| 33 | 1, 2, 3, 4, 5, 6, 7, 8, 12, 14, 15, 24, 42, 48, 54, 57, 60, 66, 69, 96, 99, 101, 102, 104, 105, 106, 107, 108, 109, 110, 111 |

**FIG 13**

| Repetierung von 8 bit (32 auf 40 bit), R=1/2 | |
|---|---|
| Pattern | zu repetierende Bits |
| 1 | 17, 19, 21, 23, 25, 27, 29, 31 |
| 2 | 13, 14, 15, 16, 17, 18, 19, 20 |
| 3 | 18, 20, 22, 24, 26, 28, 30, 32 |
| 2 | 16, 18, 20, 22, 24, 26, 28, 30 |

**FIG 14**

| Repetierung von 6 bit (74 auf 80 bit), R=1/2 | |
|---|---|
| Pattern | zu repetierende Bits |
| 1 | 35, 36, 37, 38, 39, 40 |
| 2 | 32, 34, 36, 38, 40, 42 |
| 3 | 26, 30, 34, 38, 42, 44 |
| 4 | 20, 28, 36, 44, 52, 60 |

**FIG 15**

| Repetierung von 4 bit (36 auf 40 bit), R=1/2 | |
|---|---|
| Pattern | zu repetierende Bits |
| 1 | **16, 18, 20, 22** |
| 2 | 14, 18, 20, 22 |

**FIG 16**

| Repetierung von 14 bit (54 auf 40 bit), R=1/3 | |
|---|---|
| Pattern | zu repetierende Bits |
| 1 | 1, 2, 3, 4, 7, 8, 39, 42, 45, 48, 51, 52, 53, 54 |
| 2 | 1, 2, 3, 4, 6, 7, 8, 39, 42, 48, 51, 52, 53, 54 |
| 3 | **1, 2, 3, 4, 7, 8, 36, 39, 42, 48, 51, 52, 53, 54** |
| 4 | **1, 2, 3, 4, 6, 7, 8, 39, 45, 48, 51, 52, 53, 54** |

| zusätzliche Punktierungsmuster von 111 auf 80 **Bit,** R = 1/3 | |
|---|---|
| **Muster** | zu punktierende Bits |
| 34 | 1, 2, 3, 4, 5, 6, 7, 8, 12, 13, 15, 24, 39, 44, 49, 54, 59, 64, 69 92, 96, 99,101,102,104,106,107,108,109,110,111 |
| 35 | 1, 2, 3, 4, 5, 6, 7, 8, 12, 13, 15, 24, 42, 47, 52, 57, 62, 67, 72, 92, 96, 99,101,102,104,106,107,108,109,110,111 |
| 36 | 1, 2, 3, 4, 5, 6, 7, 8, 12, 13, 15, 24, 42, 44, 49, 54, 59, 64, 69 92, 96, 99,101,102,104,106,107,108,109,110,111 |
| 37 | 1, 2, 3, 4, 5, 6, 7, 8, 12, 13, 15, 24, 39, 43, 47, 57, 61, 65, 69, 92, 96, 99,101,102,104,106,107,108,109,110,111 |
| 38 | 1, 2, 3, 4, 5, 6, 7, 8, 12, 13, 15, 39, 42, 44, 49, 54, 59, 64, 69 92, 96, 99,101,102,104,106,107,108,109,110,111 |
| 39 | 1, 2, 3, 4, 5, 6, 7, 8, 12, 13, 15, 36, 39, 44, 49, 54, 59, 64, 69 92, 96, 99,101,102,104,106,107,108,109,110,111 |
| 40 | 1, 2, 3, 4, 5, 7, 8, 13, 15, 24, 30, 35, 40, 45, 50, 55, 60, 68, 70, 75, 83, 96, 99,101,102,104,106,108,109,110,111 |
| 41 | 1, 2, 3, 4, 5, 6, 7, 8, 12, 13, 15, 24, 39, 45, 51, 57, 63, 69, 75, 92, 96, 99,101,102,104,106,107,108,109,110,111 |
| 42 | 1, 2, 3, 4, 5, 7, 8, 12, 13, 15, 24, 36, 41, 46, 51, 56, 61, 66, 71, 76, 92, 96, 99,101,102,104,106,108,109,110,111 |

Fig.17

| Punktierung von 108 auf 80 **Bit**, $R = 1/3$ | |
|---|---|
| **Muster** | zu punktierende Bits |
| 1 | 1, 2, 3, 4, 5, 6, 7, 8, 12, 13, 15, 24, 48, 54, 57, 63, 66, 69, 72, 75, 93, 96, 98, 99,101,102,103,104,105,106,107,108 |

Fig.18

**Punktierungsmuster 114→ 80, *R* = 1/3**

| Punktierung von 114 auf 80 **Bit,** $R = 1/3$ | |
|---|---|
| **Muster** | zu punktierende Bits |
| 1 | 1, 2, 3, 4, 5, 6, 7, 8, 12, 13, 15, 24, 42, 45, 48, 54, 57, 60, 66, 69, 72, 75, 99,102,104,105,107,108,109,110,111,112,113,114 |
| 2 | 1, 2, 3, 4, 5, 6, 7, 8, 12, 13, 15, 24, 42, 48, 54, 57, 60, 66, 69, 72, 96, 99,102,104,105,107,108,109,110,111,112,113,114 |
| 3 | 1, 2, 3, 4, 5, 6, 7, 8, 10, 12, 13, 15, 21, 24, 48,54,57,60,63, 66, 96, 97, 99,102,104,105,107,108,109,110,111,112,113,114 |
| 4 | 1, 2, 3, 4, 5, 6, 7, 8, 12, 13, 15, 24, 42, 48, 54, 57, 60, 66, 69, 72, 75, 96, 99,102,104,105,107,108,109,110,111,112,113,114 |
| 5 | 1, 2, 3, 4, 5, 6, 7, 8, 12, 13, 15, 24, 42, 45, 48, 54, 57, 60, 66, 69, 72, 75, 96, 99,102,104,105,107,108, 110,111,112,113,114 |
| 6 | 1, 2, 3, 4, 5, 6, 7, 8, 11, 12, 13, 15, 24, 42, 48, 54, 57, 60, 66, 69, 72, 75, 96, 99,102,104,105,107,108,110,111,112,113,114 |
| 7 | 1, 2, 3, 4, 5, 6, 7, 8, 10, 12, 13, 15, 24, 48, 54, 57, 60, 66, 69, 96, 99,101,102,104,105,107,108,109,110,111,112,113,114 |

Fig.19

## Punktierungsmuster 117→ 80, *R* = 1/3

| Punktierungsmuster von 117 auf 80 **Bit**, *R* = 1/3 | |
|---|---|
| **Muster** | zu punktierende Bits |
| 1 | 1, 2, 3, 4, 5, 6, 7, 8, 12, 13, 15, 24, 36, 40, 44, 48, 52, 56, 60, 64, 68, 72, 76, 80, 84, 98,102,105,107,108,110,112,113,114,115,116,117 |
| 2 | 1, 2, 3, 4, 5, 6, 7, 8, 12, 13, 15, 24, 39, 40, 44, 48, 52, 56, 60, 64, 68, 72, 76, 80, 84, 98,102,105,107,108,110,112,113,114,115,116,117 |
| 3 | 1, 2, 3, 4, 5, 6, 7, 8, 12, 13, 15, 24, 39, 40, 44, 51, 52, 56, 63, 64, 68, 75, 76, 80, 87, 98,102,105,107,108,110,112,113,114,115,116,117 |
| 4 | 1, 2, 3, 4, 5, 6, 7, 8, 12, 13, 15, 24, 39, 43, 47, 51, 55, 59, 63, 67, 71, 75, 79, 83, 87, 98,102,105,107,108,110,112,113,114,115,116,117 |
| 5 | 1, 2, 3, 4, 5, 7, 8, 9, 12, 13, 18, 23, 28, 33, 38, 43, 48, 53, 58, 63, 68, 73, 78, 83, 88, 93, 98, 105,106,109,110,111,113,114,115,116,117 |
| 6 | 1, 2, 3, 4, 5, 6, 7, 8, 12, 13, 15, 24, 40, 43, 46, 49, 55, 61, 64, 67, 70, 73, 76, 79, 82, 98,102,105,107,108,110,112,113,114,115,116,117 |
| 7 | 1, 2, 3, 4, 5, 7, 8, 12, 13, 15, 20, 24, 36, 40, 44, 48, 52, 56, 60, 64, 68, 72, 76, 80, 84, 87 98,102,105,107,108,110,112,114,115,116,117 |
| 8 | 1, 2, 3, 4, 5, 7, 8, 12, 13, 15, 24, 32, 36, 40, 44, 48, 52, 56, 60, 64, 68, 72, 76, 80, 84, 86 98,102,105,107,108,110,112,114,115,116,117 |
| 9 | 1, 2, 3, 4, 5, 6, 7, 8, 12, 13, 15, 24, 42, 45, 48, 51, 54, 57, 60, 63, 66, 69, 72, 75, 78, 98,102,105,107,108,110,112,113,114,115,116,117 |
| 10 | 1, 2, 3, 4, 5, 6, 7, 8, 12, 13, 15, 24, 39, 42, 45, 48, 54, 60, 63, 66, 69, 72, 75, 78, 81, |

| | |
|---|---|
| | 98,102,105,107,108,110,112,113,114,115,116,117 |
| 11 | 1, 2, 3, 4, 5, 6, 7, 8, 12, 13, 15, 24, 39, 42, 45, 48, 51, 54, 57, 60, 69, 75, 78, 81, 84, 98,102,105,107,108,110,112,113,114,115,116,117 |
| 12 | 1, 2, 3, 4, 5, 6, 7, 8, 12, 13, 15, 24, 42, 45, 48,54,57,60, 63, 66, 69, 72, 75, 78, 81, 102,105,107,108,110,111,112,113,114,115,116,117 |
| 13 | 1, 2, 3, 4, 5, 6, 7, 8, 12, 13, 15, 24, 39, 42, 45, 48, 54, 60, 63, 66, 69, 72, 75, 78, 81, 84 102,105,107,108,110,112,113,114,115,116,117 |
| 14 | 1, 2, 3, 4, 5, 6, 7, 8, 12, 13, 15, 24, 39, 42, 45, 48, 54, 60, 63, 66, 69, 72, 75, 78, 81, 99,102,105,107,108,110,111,113,114,115,116,117 |
| 15 | 1, 2, 3, 4, 5, 6, 7, 8, 12, 13, 15, 24, 36, 42, 45, 48, 54, 60, 63, 66, 69, 72, 75, 78, 81, 98,102,105,107,108,110,112,113,114,115,116,117 |

Fig.20

31

## Punktierungsmuster 52 → 40, *R* = 1/2

| Punktierung von 52 auf 40 **Bit**, *R* = 1/2 | |
|---|---|
| **Muster** | zu punktierende Bits |
| 1 | 1, 2, 3, 4, 5, 43, 45, 47, 49, 50, 51, 52 |
| 2 | 1, 2, 3, 4, 5, 45, 47, 48, 49, 50, 51, 52 |
| 3 | 1, 2, 3, 4, 15, 25, 45, 47, 49, 50, 51, 52 |
| 4 | 1, 2, 3, 4, 5, 43, 47, 48, 49, 50, 51, 52 |
| 5 | 1, 2, 3, 4, 5, 43, 45, 48, 49, 50, 51, 52 |
| 6 | 1, 2, 3, 4, 5, 25, 45, 47, 48, 49, 51, 52 |
| 7 | 1, 2, 3, 4, 5, 25, 43, 47, 48, 49, 51, 52 |
| 8 | 1, 2, 3, 4, 5, 43, 45, 47, 48, 49, 51, 52 |
| 9 | 1, 2, 3, 4, 15, 43, 45, 47, 48, 49, 51, 52 |

Fig.21

## Punktierungsmuster 46 → 40, *R* = 1/2

| Punktierung von 46 auf 40 **Bit**, *R* = 1/2 | |
|---|---|
| **Muster** | zu punktierende Bits |
| 1 | 1, 3, 39, 41, 45, 46 |
| 2 | 1, 3, 39, 41, 43, 46 |
| 3 | 1, 3, 39, 43, 45, 46 |
| 4 | 1, 2, 3, 43, 45, 46 |
| 5 | 1, 2, 39, 41, 45, 46 |
| 6 | 1, 2, 3, 39, 43, 46 |

Fig.22

**Punktierungsmuster 54 → 40, R = 1/3**

| Punktierung von 54 auf 40 **Bit**, $R = 1/3$ | |
|---|---|
| **Muster** | zu punktierende Bits |
| 1 | 1, 2, 3, 4, 6, 7, 8, 39, 42, 48, 51, 52, 53, 54 |
| 2 | 1, 2, 3, 4, 6, 7, 8, 39, 45, 48, 51, 52, 53, 54 |
| 3 | 1, 2, 3, 4, 7, 8, 39, 42, 45, 48, 51, 52, 53, 54 |
| 4 | 1, 2, 3, 4, 7, 8, 13, 39, 45, 48, 51, 52, 53, 54 |
| 5 | 1, 2, 3, 4, 7, 8, 36, 39, 42, 48, 51, 52, 53, 54 |

Fig.23

**Punktierungsmuster 56 → 40, R = 1/2**

| Punktierung von 56 auf 40 **Bit**, $R = 1/2$ | |
|---|---|
| **Muster** | zu punktierende Bits |
| 1 | 1, 2, 3, 4, 5, 6, 7, 45, 47, 49, 51, 52, 53, 54, 55, 56 |
| 2 | 1, 2, 3, 4, 5, 6, 15, 45, 47, 49, 51, 52, 53, 54, 55, 56 |
| 3 | 1, 2, 3, 4, 5, 15, 21, 29, 47, 49, 51, 52, 53, 54, 55, 56 |

Fig.24

**Repetierungsmuster 36 → 40, *R* = 1/2**

| Repetierung von 36 auf 40 **Bit**, *R* = ½ | |
|---|---|
| **Muster** | zu repetierende Bits |
| 1 | 14, 18, 20, 22 |
| 2 | 16, 18, 20, 22 |
| 3 | 14, 17, 10, 23 |
| 4 | 10, 15, 20, 25 |
| 5 | 13, 16, 19, 22 |

Fig.25

| Punktierung von 48 auf 40 **Bit** | |
|---|---|
| **Muster** | zu punktierende Bits |
| 1 | 1, 8, 15, 22, 28, 35, 42, **48** |
| 2 | 1, 2, 10, 18, 25, 33, 41, **48** |
| 3 | 1, 2, 3, 12, 21, 30, 39, **48** |
| 4 | 1, 2, 3, 4, 15, 26, 37, **48** |
| 5 | 1, 2, 3, 4, 5, 20, 34, **48** |
| 6 | 1, 2, 3, 4, 5, 6, 27, **48** |

Fig. 26

| Figur 27: Punktierung von 111 auf 80 **Bit** | |
|---|---|
| **Muster** | zu punktierende Bits |
| 1 | 1, 5, 8, 11, 14, 17, 20, 23, 26, 29, 32, 35, 38, 41, 44, 47, 50, 53, 56, 60, 63, 66, 69, 72, 75, 78, 81, 84, 87, 90, 93, 96, 99,102,105,108,**111** |
| 2 | **1, 2,** 6, 9, 12, 15, 18, 21, 24, 27, 31, 34, 37, 40, 43, 46, 49, 52, 55, 59, 62, 65, 68, 71, 74, 77, 80, 83, 87, 90, 93, 96, 99,102,105,108,**111** |
| 3 | **1, 2, 3,** 7, 10, 13, 16, 19, 23, 26, 29, 32, 35, 38, 42, 45, 48, 51, 54, 57, 61, 64, 67, 70, 73, 77, 80, 83, 86, 89, 92, 96, 99,102,105,108,**111** |
| 4 | **1 , 2, 3, 4,** 8, 11, 14, 17, 21, 24, 27, 30, 34, 37, 40, 43, 47, 50, 53, 56, 60, 63, 66, 69, 73, 76, 79, 82, 86, 89, 92, 95, 99,102,105,108,**111** |
| 5 | **1, 2, 3, 4, 5,** 9, 12, 15, 19, 22, 25, 29, 32, 35, 39, 42, 45, 49, 52, 55, 58, 62, 65, 68, 72, 75, 78, 82, 85, 88, 92, 95, 98,102,105,108,**111** |
| 6 | **1, 2, 3, 4, 5, 6,** 10, 13, 17, 20, 23, 27, 30, 34, 37, 40, 44, 47, 51, 54, 57, 61, 64, 67, 71, 74, 78, 81, 84, 88, 91, 95, 98,101,105,108,**111** |
| 7 | **1, 2, 3, 4, 5, 6, 7,** 11, 14, 18, 21, 25, 28, 32, 35, 39, 42, 46, 49, 53, 56, 59, 63, 66, 70, 73, 77, 80, 84, 87, 91, 94, 98,101,105,108,**111** |
| 8 | **1, 2, 3, 4, 5, 6, 7, 8,** 12, 16, 19, 23, 26, 30, 33, 37, 40, 44, 48, 51, 55, 58, 62, 65, 69, 72, 76, 80, 83, 87, 90, 94, 97,101,104,108,**111** |
| 9 | **1, 2, 3, 4, 5, 6, 7, 8, 9,** 13, 17, 20, 24, 28, 31, 35, 39, 42, 46, 50, 53, 57, 60, 64, 68, 71, 75, 79, 82, 86, 90, 93, 97,101,104,108,**111** |
| 10 | **1, 2, 3, 4, 5, 6, 7, 8, 9, 10,** 14, 18, 22, 25, 29, 33, 37, 40, 44, 48, 52, 55, 59, 63, 67, 70, 74, 78, 82, 85, 89, 93, 97,100,104,108,**111** |
| 11 | **1, 2, 3, 4, 5, 6, 7, 8, 9, 10, 11,** 15, 19, 23, 27, 31, 35, 38, 42, 46, 50, 54, 58, 61, 65, 69, 73, 77, 81, 85, 88, 92, 96,100,104,108,**111** |

```
if puncturing is to be performed

    e = e_ini                        -- initial error between current and desired puncturing ratio

    m = 1                            -- index of current bit

    do while m <= X_i

        e = e - e_minus                  -- update error

        if e <= 0 then                   -- check if bit number m should be punctured

            set bit x_i,m to δ where δε{0, 1}

            e = e + e_plus -- update error

        end if

        m = m + 1                                    -- next bit

    end do

else

    e = e_ini                .  .                    -- initial error between current and desired puncturing ratio

    m = 1                                            -- index of current bit

    do while m <= X_i -

        e = e - e_minus                              -- update error

        do while e <= 0                              -- check if bit number m should be repeated

            repeat bit x_i,m

            e = e + e_plus              -- update error

        end do

        m = m + 1                                    -- next bit

    end do

end if
```

Fig. 28

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• WO 0139420 A

**In der Beschreibung aufgeführte Nicht-Patentliteratur**

• Multiplexing and channel coding (FDD) (Release 5. *Spezifikation 3GPP TS 25.212 V5.0.0,* Marz 2002